(19) Europäisches Patentamt
European Patent Office
Office européen des brevets

(11) **EP 3 703 138 B1**

(12) **FASCICULE DE BREVET EUROPEEN**

(45) Date de publication et mention
de la délivrance du brevet:
**20.10.2021 Bulletin 2021/42**

(51) Int Cl.:
***H01L 31/0232*** *(2014.01)*   ***H01L 31/103*** *(2006.01)*

(21) Numéro de dépôt: **20159364.7**

(22) Date de dépôt: **25.02.2020**

(54) **STRUCTURE DE DÉTECTION DE RAYONNEMENT ÉLECTROMAGNÉTIQUE À HAUTE EFFICACITÉ D'ABSORPTION ET UN PROCÉDÉ DE FABRICATION D'UNE TELLE STRUCTURE**

STRUKTUR ZUR ERKENNUNG EINER ELEKTROMAGNETISCHEN STRAHLUNG MIT HOHER ABSORPTIONSEFFIZIENZ, UND HERSTELLUNGSVERFAHREN EINER SOLCHEN STRUKTUR

STRUCTURE FOR DETECTING ELECTROMAGNETIC RADIATION WITH HIGH ABSORPTION EFFICIENCY AND METHOD FOR MANUFACTURING SUCH A STRUCTURE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.02.2019 FR 1902036**

(43) Date de publication de la demande:
**02.09.2020 Bulletin 2020/36**

(73) Titulaire: **Commissariat à l'énergie atomique et aux énergies alternatives**
**75015 Paris (FR)**

(72) Inventeur: **LE PERCHEC, Jérôme**
**38054 GRENOBLE Cedex 09 (FR)**

(74) Mandataire: **Brevalex**
**95, rue d'Amsterdam**
**75378 Paris Cedex 8 (FR)**

(56) Documents cités:
**FR-A1- 2 842 945     FR-A1- 2 992 471**
**US-A1- 2018 212 080**

## Description

## Domaine technique

L'invention concerne le domaine de l'optoélectronique et des composants optoélectroniques adaptés pour détecter des rayonnements électromagnétiques.

Ainsi l'invention a pour objet une structure de détection de rayonnement électromagnétique et un procédé de fabrication d'une telle structure de détection.

## État de l'art antérieur

Les structures de détection de rayonnement électromagnétique sont connues pour présenter un courant d'obscurité non nul, ce qui participe à dégrader le rapport signal sur bruit. Le courant d'obscurité a pour origine la génération de paires électron-trou non photogénérées dans la structure. Or cette génération a principalement lieu dans une zone active de la structure dans laquelle les photons sont absorbés pour générer le signal. Cette zone, pour maximiser le signal, doit occuper une grande partie du volume de la structure, celle-ci s'étendant généralement sur la quasi-totalité de la surface de la structure, et est donc à l'origine d'un bruit important.

Ceci est d'autant plus vrai pour les structures adaptées pour fonctionner dans les longueurs d'onde infrarouge, ces dernières étant sujettes à un bruit important en raison de la faible largeur de bande interdite du matériau dans lequel elles sont formées. En effet, une faible largeur de bande interdite favorise la formation d'un courant d'obscurité tunnel dans la zone active.

Pour remédier à cet inconvénient, il est connu de concentrer le rayonnement électromagnétique dans une zone réduite de la structure dans laquelle est ménagée la jonction et donc la zone active. Ainsi, la structure peut recevoir le rayonnement électromagnétique sur une surface importante sans pour autant nécessiter une zone active occupant un volume important.

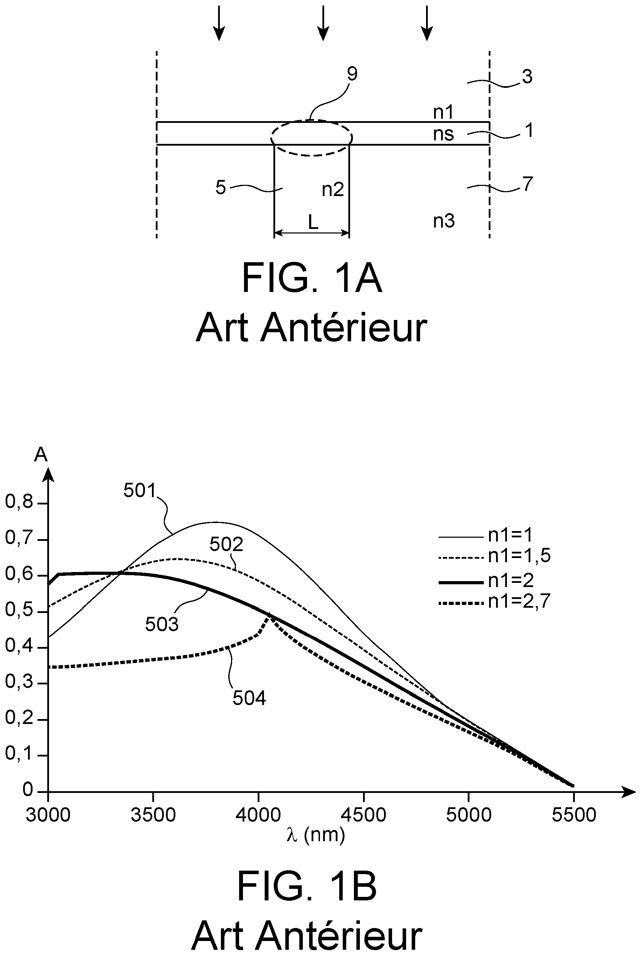

Afin de fournir une telle concentration du rayonnement électromagnétique et donc de réduire le courant d'obscurité, il est connu de l'art antérieur, par exemple du document FR2992471A1 et notamment du document US 8125043 B2, comme illustré sur la figure 1 extraite de ce document, de coupler une couche d'absorption 1 avec une cavité résonnante du type Fabry-Perot pour former une structure de détection de rayonnement électromagnétique.

Dans ce document, la structure de détection comporte ainsi :

- un support présentant une face de réception pour recevoir le rayonnement électromagnétique, et dans lequel est aménagé une cavité Fabry-Perot logeant au moins un premier milieu de confinement 5 d'indice $n_2$, la cavité Fabry-Perot s'étendant selon le long d'une épaisseur dudit support en débouchant dans une ouverture de la face de réception et étant délimitée par un milieu réflecteur 7 avec au moins une longueur de cavité Fabry-Perot moyenne L,

- une couche d'absorption 1, configurée pour absorber le rayonnement électromagnétique et agencée en contact avec la cavité Fabry-Perot, la couche d'absorption 1 présentant un indice de réfraction $n_s$, ladite région présentant une épaisseur comprise entre $\lambda_0/(4.n_s)$ et $\lambda_0/(20.n_s)$.

Conformément à l'enseignement de ce document, la longueur de cavité Fabry-Perot L est sensiblement égale à $\lambda_0/(n_s)$.

Une telle configuration permet de piéger la lumière reçue par la couche d'absorption dans une zone 9 de la couche d'absorption qui est délimitée par la cavité Fabry-Perot. On entend ci-dessus par « piégeage de la lumière » une amplification locale du champ électrique au sein de la zone 9 de la couche d'absorption.

Néanmoins, si, dans une configuration idéale de la structure décrite par le document US 8125043 B2, celle-ci présente une bonne sélectivité, dans le cas où l'on considère la configuration de principe qui est illustrée sur la figure 1 reprise dans le présent document par la figure 1A, l'adjonction d'une couche de passivation afin de passiver la couche d'absorption 1, conformément à la pratique usuelle de l'homme du métier, est préjudiciable en raison de l'indice de réfraction élevé d'une telle couche de passivation.

En effet, cela est montré sur des simulations de la variation de l'absorption d'une telle structure en fonction de la longueur d'onde du rayonnement électromagnétique à absorber effectuées par l'inventeur et dont les résultats sont illustrés par la figure 1B. La configuration utilisée pour ces simulations est la suivante :

- un milieu incident 3 dont l'indice de réfraction a été varié, l'inventeur ayant simulé la structure pour un indice de réfraction $n_1$ de 1 (courbe 501), 1,5 (courbe 502), 2 (courbe 503), et 2.7 (courbe 504) sachant que dans une application pratique utilisant des tellurures de mercure cadmium CdHgTe en tant que couche d'absorption, les milieux incident pouvant servir de couche de passivation de la couche d'absorption étant généralement en tellurure de cadmium dont l'indice de réfraction est de 2.7,

- une couche d'absorption 9 réalisée dans un tellurure de mercure cadmium CdHgTe présentant un indice de réfraction $n_s$ égale à 3,5 et d'une épaisseur $h_a$ de 150 nm, soit une épaisseur $h_a$ environ égale à $\lambda_0/(7.n_s)$ pour $\lambda_0$ égale à 3,8 $\mu$m,

- une cavité Fabry-Perot de 0,9 $\mu$m de largeur, le milieu réflecteur 7 étant de l'or et le milieu de confinement du dioxyde de silicium d'indice de réfraction $n_s$ 1,5.

Comme montré sur la figure 1B, l'inventeur a constaté que, pour une structure selon une application pratique de la structure du document US 8125043 B2 :

(i) conformément à l'enseignement de ce document, le champ électromagnétique est confiné dans une couche d'absorption 1 et non sur le métal fournissant le milieu réflecteur 7, ce qui permet de limiter les pertes à l'interface couche d'absorption/ métal,

(ii) la résonance n'est pas très marquée et rend la structure peu sélective en fréquence, ceci avec une efficacité quantique maximum relativement modérée puisqu'on observe une absorption maximale de 75% qui est obtenue pour un indice de réfraction de 1 du milieu incident 3,

(iii) une augmentation de l'indice de réfraction du milieu incident entraîne, comme le montrent les courbes d'absorption 501 à 504 , une baisse de la sélectivité, le pic d'absorption s'élargissant, et une baisse de l'absorption maximale.

Or concernant le point (iii) et comme indiqué ci-dessus, avec une couche d'absorption 1 en tellurure de mercure cadmium CdHgTe, le milieu incident 3 devant servir de passivation à ladite couche d'absorption, présente un indice de réfraction de l'ordre de 2,7. Il en résulte qu'une telle structure selon une application pratique du document US 8125043 B2 ne présente pas la sélectivité et les performances attendues.

Il est donc nécessaire de développer une structure de détection qui présente un taux d'absorption et une sélectivité optimisée même en cas d'utilisation d'une couche de passivation de la couche d'absorption, comme cela est généralement nécessaire pour une telle structure de détection. On notera que cette problématique est particulièrement présente dans le cas d'une structure dont la couche d'absorption est réalisée en tellurure de mercure cadmium CdHgTe.

**Présentation de l'invention**

L'invention a pour objet de fournir une structure de détection susceptible de présenter une région d'absorption passivée et qui, contrairement aux structures de l'art antérieur, dans une telle configuration, présente un taux d'absorption et une sélectivité en fréquence optimisés, ceci notamment par une association de la région d'absorption à une cavité Fabry-Perot.

L'invention concerne à cet effet une structure de détection de rayonnements électromagnétiques adaptée pour détecter un rayonnement électromagnétique dans au moins une première plage de longueurs d'onde donnée centrée autour d'une première longueur d'onde $\lambda_0$, la structure de détection comprenant :

- un support présentant une face de réception agencée pour recevoir au moins une partie du rayonnement électromagnétique et dans lequel est aménagé une cavité Fabry-Perot s'étendant au moins en partie le long d'une d'épaisseur dudit support, ladite cavité Fabry-Perot débouchant sur une première ouverture de ladite face de réception et étant délimitée par au moins un milieu conducteur à permittivité négative dudit support, la cavité Fabry-Perot présentant, sur au moins une première partie de l'épaisseur du support incluant la face de réception et selon au moins une direction sensiblement parallèle à la face de réception, une longueur de cavité Fabry-Perot moyenne Wc, la cavité Fabry-Perot logeant au moins un premier milieu de confinement d'indice de réfraction $n_d$,

- une région d'absorption, configurée pour absorber le rayonnement électromagnétique, la région d'absorption présentant un indice de réfraction $n_a$.

Dans laquelle structure de détection :

- la longueur de cavité Fabry-Perot moyenne Wc est sensiblement égale à $\lambda_0/(2.n_{eff})$, avec $n_{eff}$ un indice de réfraction effectif d'un mode guidé dans la région d'absorption à la longueur d'onde $\lambda_0$,
- la région d'absorption présente une épaisseur $h_a$ inférieure à $\lambda_0/(5.n_a)$,
- la région d'absorption est logée dans la cavité Fabry-Perot à une distance $h_1$ de la première ouverture de ladite cavité Fabry-Perot comprise entre $\lambda_0/(50.n_d)$ et $\lambda_0/(4.n_d)$,
- l'épaisseur de l'au moins une première partie étant égale ou supérieure à hi,
- l'indice de réfraction $n_d$ de l'au moins un premier milieu de confinement étant inférieur à 80% de l'indice de réfraction $n_a$ de la région d'absorption.

Dans une telle structure de détection, la région d'absorption n'est pas, ceci en raison de son logement dans la cavité Fabry-Perot et de la différence d'indice entre la région d'absorption et le milieu de confinement, sujet phénomènes de fuites radiatives qui sont observées dans à la structure de détection selon le document US 8125043 B2.

En effet dans la structure de détection du document US 8125043 B2, l'augmentation d'indice $n_1$ induit par l'utilisation d'une couche de passivation entraine une déconcentration, ou étalement, de la distribution de champ électrique en dehors de la zone 9. Ceci induit une perte d'absorption utile dans la zone 9 et donc une résonance de moins bonne qualité comme observé par l'inventeur dans les simulations illustrées par la figure 1B. Or dans la structure selon l'invention, La présence de la cavité Fabry-Perot permet d'éviter une telle déconcentration/étalement de la distribution de champ électrique et donc de conserver une résonance de bonne qualité.

Avec une telle structure de détection, il est donc possible de bénéficier, comme pour la structure enseignée par le document US 8125043 B2, de l'association de la cavité Fabry-Perot avec le mode guidé présent dans la région d'absorption, ceci tout en ayant une passivation de la région d'absorption fournie par le milieu incident sans dégradation de la résonnance de la structure de détection.

Ainsi, une telle structure de détection est à même de présenter une absorption optimisée et une bonne sélectivité même dans une configuration pratique de l'invention.

Par milieu conducteur à permittivité négative, il est entendu que ce milieu présente une permittivité négative dans au moins la première plage de longueurs d'onde donnée. Ainsi de tels milieux conducteurs à permittivité négative comprennent les réflecteurs métalliques, en particulier les métaux nobles, tel que par exemple l'or Au, l'argent Ag ou l'aluminium Al, les cristaux ioniques, éventuellement dopés dont la bande de Restsrahlen comprend la première plage de longueurs d'onde donnée, tel que par exemple du carbure de silicium SiC pour une plage de longueurs d'onde donnée dans l'infrarouge, ou encore un semiconducteur dopé présentant un comportement métallique dans la plage de longueurs d'onde donnée , tel que du silicium amorphe aSi pour une plage de longueur d'onde donnée dans l'ultra-violet.

On entend ci-dessus et dans le reste de ce document, par une grandeur sensiblement égale à une autre grandeur donnée que ladite grandeur présente une valeur se différentiant de ladite autre grandeur donnée de moins de 10%, voire 5% et avantageusement 2%, de ladite autre grandeur donnée.

On entend ici et dans le reste de ce document par distance entre un premier élément, tel que la couche d'absorption, et un deuxième élément, tel que l'ouverture, la distance minimale entre les surfaces de chacun desdits premier et deuxième éléments qui sont en regard l'une de l'autre. Ainsi dans le cas de la distance entre la couche d'absorption et de la première ouverture, la distance $h_1$ correspond à la distance entre la face de la couche d'absorption et le plan de la face de réception dans lequel est aménagée la première ouverture.

La cavité Fabry-Perot présente sur une deuxième partie de l'épaisseur du support au moins une dimension selon au moins une direction sensiblement parallèle à la face de réception comprise entre 80% et 120% de la longueur de cavité Fabry-Perot moyenne Wc.

Cette modularité de la largeur peut provenir des moyens de réalisation technologiques tels que décrits dans les modes de réalisation pratique ci-après et peut permettre de minimiser l'éventuelle fuite radiative lorsqu'une deuxième ouverture est prévue à l'opposé de la première ouverture ceci afin d'optimiser la qualité de la résonance.

La région d'absorption peut être aménagée dans une couche d'absorption, ladite couche d'absorption s'étendant en dehors de la cavité Fabry-Perot selon un plan sensiblement parallèle à la face de réception.

Cette extension peut provenir naturellement de l'empilement multicouche initial à partir duquel la structure détectrice est réalisée (par exemple un empilement semi-conducteur formé par épitaxie).

la cavité Fabry-Perot peut être, à l'opposé de la première ouverture, au moins en partie fermée par une paroi réflectrice configurée pour réfléchir le rayonnement électromagnétique, ladite paroi réflectrice étant agencée à une distance $h_3$ de la région d'absorption qui est comprise entre $\lambda_0/(10.n_d)$ et $\lambda_0/(2.n_d)$, avec $n_d$ l'indice de réfraction du premier milieu de confinement, ladite distance $h_3$ entre la paroi réflectrice et la région d'absorption étant préférentiellement comprise entre $\lambda_0/(7.n_d)$ et $\lambda_0/(4.n_d)$ et avantageusement sensiblement égale $\lambda_0/(5.n_d)$.

La cavité Fabry-Perot présente, à l'opposé de la première ouverture, une deuxième ouverture, la distance h2 entre ladite deuxième ouverture et la région d'absorption étant supérieure à λ0/(2.nd).

la structure de détection peut comprendre au moins une couche d'adaptation d'indice de réfraction $n_r$ disposée entre la région d'absorption et le milieu de confinement, ladite couche d'adaptation d'indice de réfraction présentant un indice de réfraction dont la valeur reste comprise entre l'indice de réfraction $n_d$ de l'au moins un milieu de confinement et l'indice de réfraction $n_a$ de la couche d'absorption en diminuant de la région d'absorption vers le milieu de confinement.

Ce gradient d'indice peut résulter de procédés technologiques (par exemple de recuits thermiques) qui permettent avantageusement de minimiser la recombinaison de photo-porteurs aux interfaces.

La structure de détection peut comprendre un deuxième milieu de confinement, ledit deuxième milieu de confinement étant logé dans la cavité Fabry-Perot à l'opposé de la première ouverture avec le premier milieu de confinement s'interposant entre la région d'absorption et ledit deuxième milieu de confinement, le deuxième milieu de confinement présentant un indice de réfraction $n_{d'}$ inférieur à l'indice de réfraction $n_d$ du premier milieu de confinement.

Avec une telle configuration, il est notamment possible de limites Les fuite de rayonnement au niveau de la deuxième ouverture de cavité quand la cavité en comprend une à l'opposé de la première cavité.

L'au moins un premier milieu de confinement peut en outre être disposé à l'extérieur de la cavité Fabry Perot, ledit premier milieu de confinement formant, pour sa partie extérieure à la cavité Fabry-Perot, un revêtement du milieu conducteur à permittivité négative d'une épaisseur $h_1'$ inférieure à $h_1$.

Une telle configuration est particulièrement avantageuse pour un milieu extérieur tel que de l'air ($n_{ext}=1$), la fine couche du milieu de confinement formant alors une couche de protection/passivation et est fournie une fonction d'antireflet.

La structure de détection peut comprendre en outre un milieu incident amont du support, dans le sens propagation du rayonnement électromagnétique, le milieu incident étant configuré pour recevoir le rayonnement électromagnétique et le transmettre au support, le milieu incident présentant un indice de réfraction $n_{ext}$ inférieure ou égale à l'indice de réfraction $n_d$ du premier milieu de confinement,

le premier milieu de confinement étant intégralement contenu dans la cavité Fabry-Perot.

L'invention concerne en outre un dispositif de détection de rayonnements électromagnétiques comprenant une pluralité de structures de détection selon l'invention, chacune des structures de détection étant adaptée pour détecter un rayonnement électromagnétique dans l'au moins une première plage de longueurs d'onde donnée centrée autour de la première longueur d'onde $\lambda_0$, lesdites structures de détection étant agencées périodiquement avec une périodicité inférieure à $\lambda_0/n_{ext}$ où $n_{ext}$ est l'indice de réfraction d'un milieu incident amont du support, dans le sens propagation du rayonnement électromagnétique, et de préférence inférieure à 75% de $\lambda_0/n_{ext}$.

Avec une telle configuration on évite les risques que des phénomènes de diffraction perturbent la détection par les structures de détection.

L'invention concerne en outre un procédé de fabrication d'une structure de détection de rayonnements électromagnétiques adaptée pour détecter un rayonnement électromagnétique dans au moins une première plage de longueurs d'onde donnée centrée autour d'une première longueur d'onde $\lambda$o, le procédé de fabrication comprenant les étapes suivantes :

- fourniture d'une région d'absorption d'une épaisseur $h_a$ inférieure à $\lambda_0/(5.n_a)$ , ladite région d'absorption présentant un indice de réfraction $n_a$ et étant associée avec au moins un milieu de confinement d'indice de réfraction $n_d$ inférieur à 80% de l'indice de réfraction $n_a$ de la région d'absorption,
- formation d'une cavité Fabry-Perot de manière à y loger au moins en partie l'au moins un premier milieu de confinement et la région d'absorption, la cavité Fabry-Perot étant délimitée latéralement par au moins un premier milieu conducteur à permittivité négative avec un $n_{eff}$ un indice de réfraction effectif d'un mode guidé dans la région d'absorption à la longueur d'onde $\lambda_0$, ladite cavité Fabry-Perot logeant la région d'absorption à une distance $h_1$ de la première ouverture de ladite cavité Fabry-Perot comprise entre $\lambda_0/(50.n_d)$ et $\lambda_0/(4.n_d)$, , ladite formation de la cavité Fabry Perot permettant de former un support présentant une face de réception présentant la première ouverture dans laquelle débouche la cavité Fabry Perot, la cavité Fabry-Perot s'étendant au moins en partie le long d'une d'épaisseur dudit support et présentant, sur au moins une première partie de l'épaisseur du support incluant la face de réception et selon au moins une direction sensiblement parallèle à la face de réception, une longueur de cavité Fabry-Perot moyenne Wc sensiblement égale à $\lambda_0/(2.n_{eff})$, avec $n_{eff}$ un indice de réfraction effectif d'un mode guidé dans la région d'absorption à la longueur d'onde $\lambda_0$.

Un tel procédé permet la fourniture d'une structure selon l'invention qui bénéficie, de fait, des avantages liés à l'invention.

Lors de l'étape de fourniture de la région d'absorption, il est fourni le support comprenant un substrat, une couche d'absorption et une couche de passivation se succédant, au moins l'un du substrat et de la couche de passivation étant destiné à former l'au moins un milieu de confinement,

l'étape de formation d'une cavité Fabry-Perot comprenant les sous-étapes suivantes de :

- gravure localisée du support de manière à former au moins une première percée correspondant au milieu conducteur à permittivité négative, l'au moins une percée délimitant une cavité logeant au moins en partie le milieu de confinement et la région d'absorption,
- remplissage de l'au moins une percée par le matériau du milieu conducteur à permittivité négative de manière à former ledit milieu conducteur à permittivité négative et donc la cavité Fabry-Perot.

Une telle étape de formation permet une formation de la cavité Fabry-Perot avec un nombre réduit d'étapes.

Il peut en outre il peut en outre être prévu les étapes de :

- fourniture d'un deuxième support comprenant un circuit de commande, ledit circuit de commande présentant au moins un plot de contact,
- connexion de la structure de détection au circuit de commande par hybridation par bille d'indium du milieu réflecteur conducteur au premier plot de contact.

Il est prévu, préalablement à l'étape de gravure localisée, les étapes suivantes :

- fourniture d'un deuxième support comprenant un circuit de commande, ledit circuit de commande présentant au moins un plot de contact,
- collage du premier support sur une face du premier support comprenant l'au moins un plot de contact,

dans lequel lors de la sous-étape de gravure localisé, l'au moins une percée débouche sur le plot de contact, de tel manière que lors de la sous-étape remplissage de l'au moins une percée, le matériau conducteur à permittivité négative est également déposé en contact de l'au moins un plot de contact.

Ces deux possibilités permettent d'associer la structure de détection selon l'invention avec un deuxième support comprenant un circuit de commande.

**Brève description des figures**

La présente invention sera mieux comprise à la lecture de la description d'exemples de réalisation, donnés à titre purement indicatif et nullement limitatif, en faisant référence aux dessins annexés sur lesquels :

- les figures 1A et 1B illustrent respectivement une structure de l'art antérieur et un graphique du taux d'absorption en fonction de la longueur d'onde d'un rayonnement électromagnétique à absorber qui est susceptible d'être obtenue avec une telle structure,

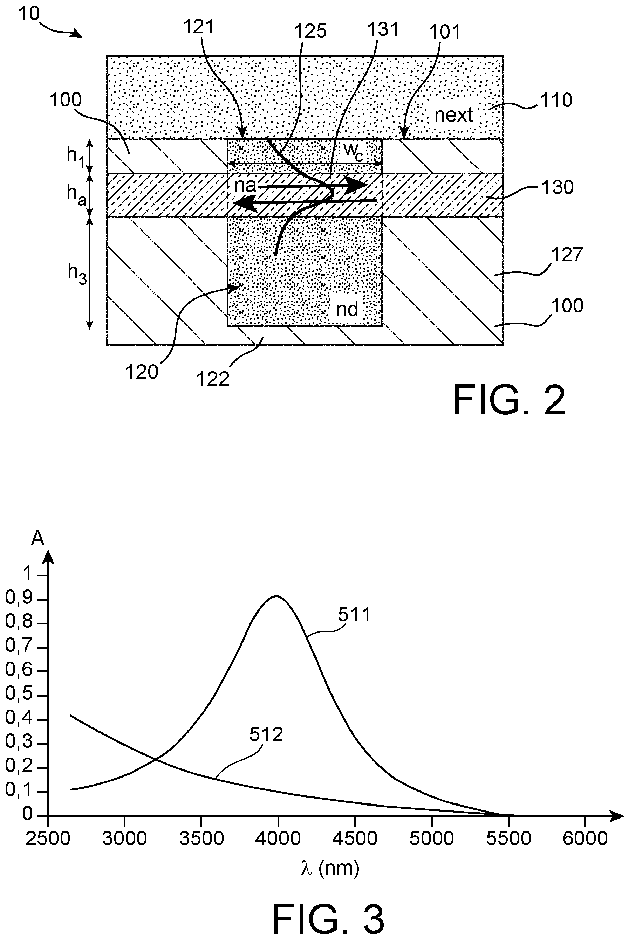

- la figure 2 illustre schématiquement une structure selon le principe de l'invention,
- la figure 3 illustre graphiquement la variation du taux d'absorption en fonction de la longueur d'onde du rayonnement électromagnétique à absorber pour une structure selon le principe de l'invention illustrée sur la figure 2 en parallèle avec le taux d'absorption d'une couche d'absorption identique à celle de la structure de la figure 2 disposée sur une surface d'or,

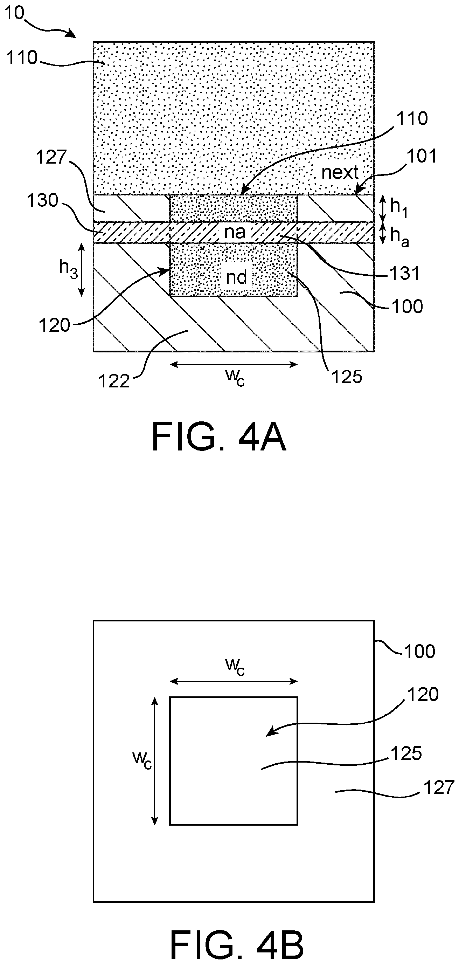

- les figures 4A à 4C illustrent schématiquement une structure selon une première possibilité de l'invention dans laquelle la structure comporte une cavité Fabry-Perot fermée à une extrémité, les figures 4A à 4C illustrant respectivement une vue en coupe de ladite structure, une vue de dessous de ladite structure et une cartographie du champ électrique dans une telle structure le long de la coupe de la structure de détection montrée sur la figure 4A,

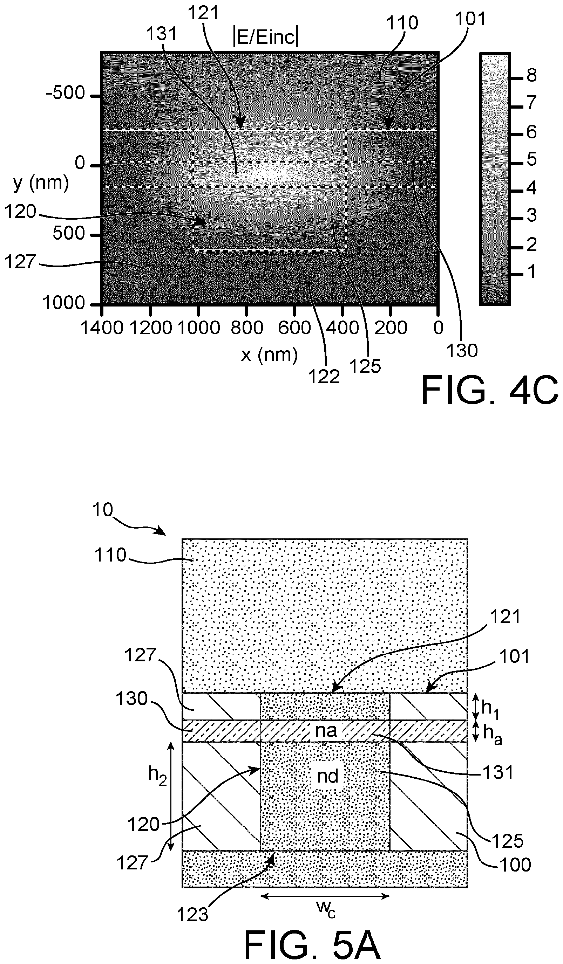

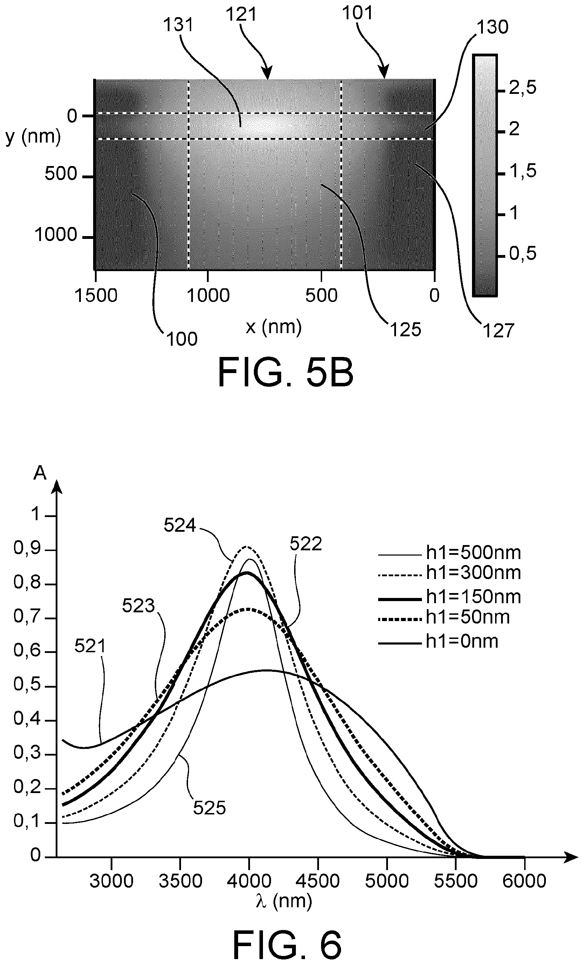

- les figure 5A et 5B illustrent schématiquement une structure selon une deuxième possibilité de l'invention dans laquelle la structure comporte une cavité Fabry-Perot ouverte à ces deux extrémités, les figures 5A et 5V illustrant respectivement une vue en coupe de ladite structure et une cartographie du champ électrique dans une telle structure le long de la coupe de la structure de détection montrée sur la figure 5A,
- la figure 6 illustre graphiquement la variation de l'absorption d'une structure selon l'invention en fonction de la longueur d'onde du rayonnement électromagnétique pour une distance $h_1$ croissante entre une région d'absorption et une ouverture de la cavité Fabry-Perot,

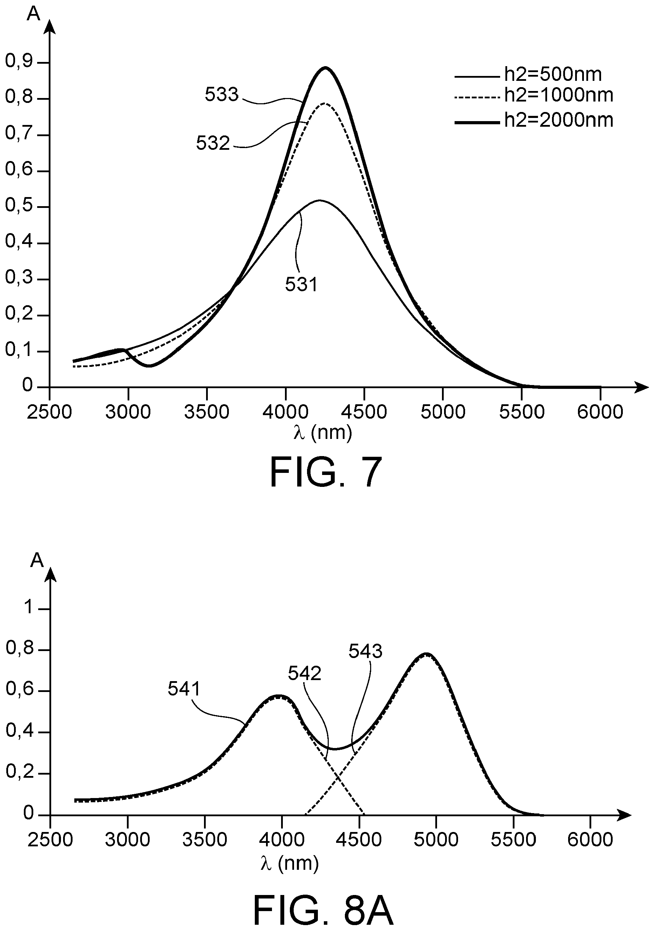

- la figure 7 illustre graphiquement la variation de l'absorption d'une structure selon la deuxième possibilité de l'invention en fonction de la longueur d'onde du rayonnement électromagnétique pour une distance $h_2$ croissante entre une deuxième ouverture de la structure et la région d'absorption,
- les figures 8A à 8C illustrent respectivement la variation de l'absorption d'une structure comprenant deux cavités Fabry-Perot avec chacune une région d'absorption aménagée dans une couche d'absorption commune auxdites cavités en fonction de la longueur d'onde du rayonnement électromagnétique, une cartographie du champ électromagnétique dans une telle structure pour un rayonnement électromagnétique correspondant à la longueur d'onde de résonance de la première cavité, et une cartographie du champ électromagnétique dans une telle structure pour un rayonnement électromagnétique correspondant à la longueur d'onde de résonance de la deuxième cavité,

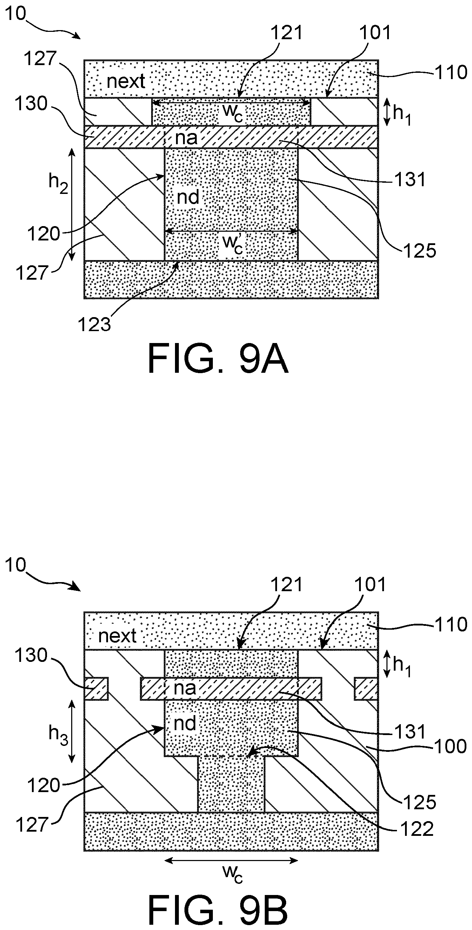

- les figures 9A à 9H illustrent par des vues en coupe latérale d'une structure selon respectivement une première variante de l'invention dans laquelle la cavité Fabry-Perot présente une largeur différente entre une première partie comprise entre la première ouverture de la cavité et la région d'absorption et une deuxième partie entre la région d'absorption et la deuxième ouverture de la cavité, une deuxième variante de l'invention dans laquelle la couche d'absorption est discontinue et dans laquelle la cavité est partiellement fermée, une troisième variante de l'invention dans laquelle la région d'absorption est localement discontinue ou indentée, une quatrième variante de l'invention dans laquelle la deuxième partie de la cavité Fabry-Perot comprend un deuxième milieu de confinement présentant un indice de réfraction inférieur à celui du premier milieu de confinement, une cinquième variante de l'invention dans laquelle le matériau du milieu de confinement forme également une passivation de la structure, une sixième variante de l'invention dans laquelle la couche d'absorption présente un gradient d'indice optique avec le milieu de confinement adjacent, une septième variante dans laquelle dans laquelle uniquement la région d'absorption présente un gradient d'indice optique avec le milieu de confinement adjacent et une huitième variante dans laquelle la cavité Fabry-Perot présente, sur première partie de sa hauteur, une section variable,

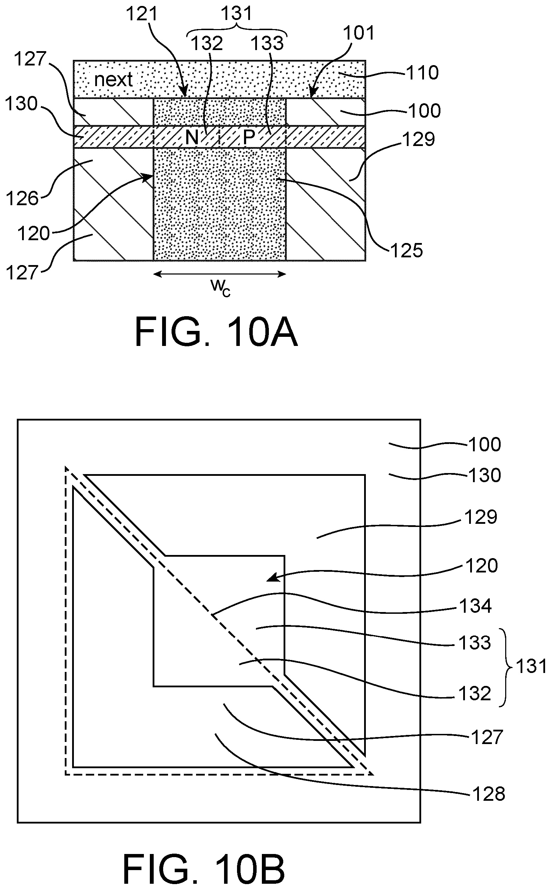

- les figure 10A à 10B illustrent une structure selon un premier mode de réalisation pratique de l'invention dans laquelle la cavité présente une section transversale carrée, la région d'absorption formant une structure de diode avec une jonction semiconductrice selon une diagonale de ladite section latérale carrée, les figures 10A et 10B illustrant respectivement une vue en coupe latérale et une vue en coupe selon un plan de couche d'une telle structure,

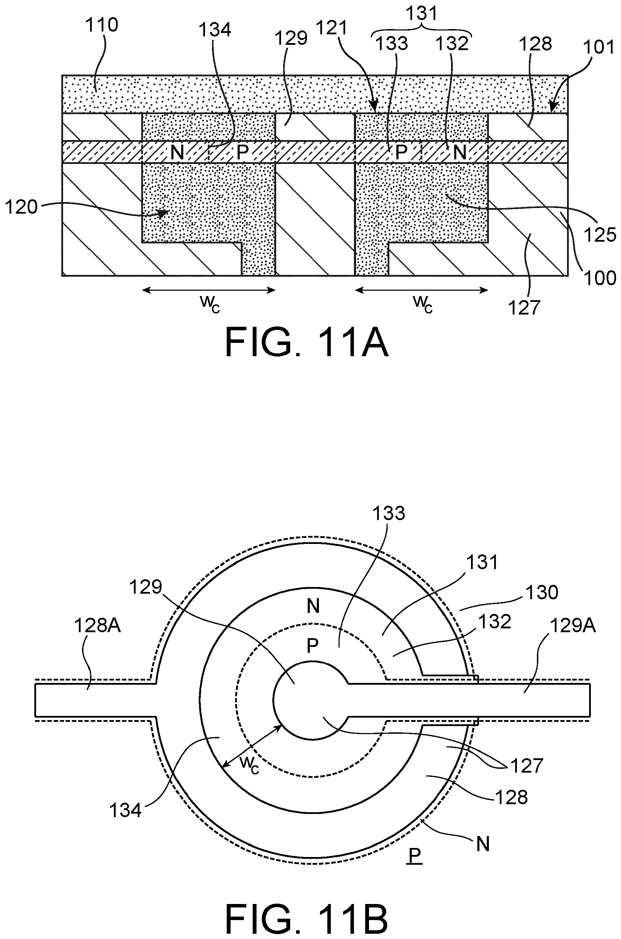

- les figures 11A et 11B illustrent respectivement une structure selon un deuxième mode de réalisation pratique de l'invention dans lequel la cavité Fabry-Perot présente une forme annulaire, les figures 11A et 11B montrant respectivement une vue en coupe latérale et une vue en coupe selon le plan de couche de ladite structure,

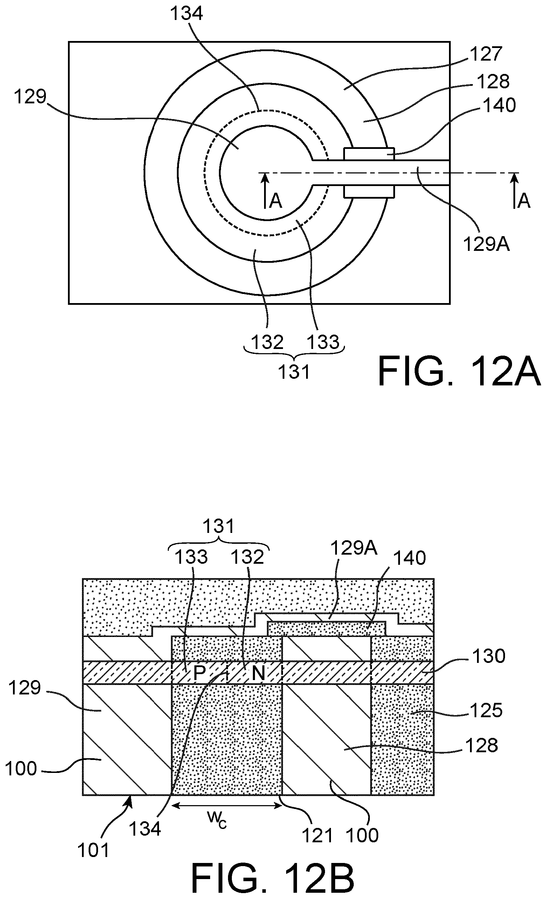

- les figures 12A et 12B illustrent l'agencement pratique d'une structure selon le deuxième mode de réalisation illustré sur les figures 11A et 11B, les figures 12A et 12B montrant respectivement une vue de dessus et une vue en coupe latérale d'une telle structure,

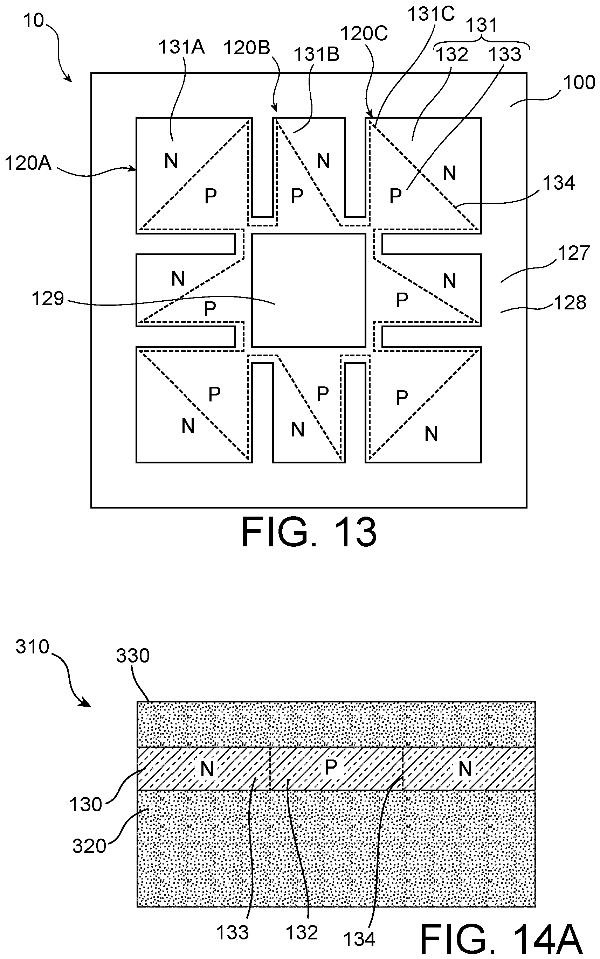

- la figure 13 illustre schématiquement et en vue en coupe selon le plan de couche une structure selon un troisième mode de réalisation pratique de l'invention dans lequel la structure présente un contact central et huit cavités Fabry-Perot agencées autour dudit contact central,

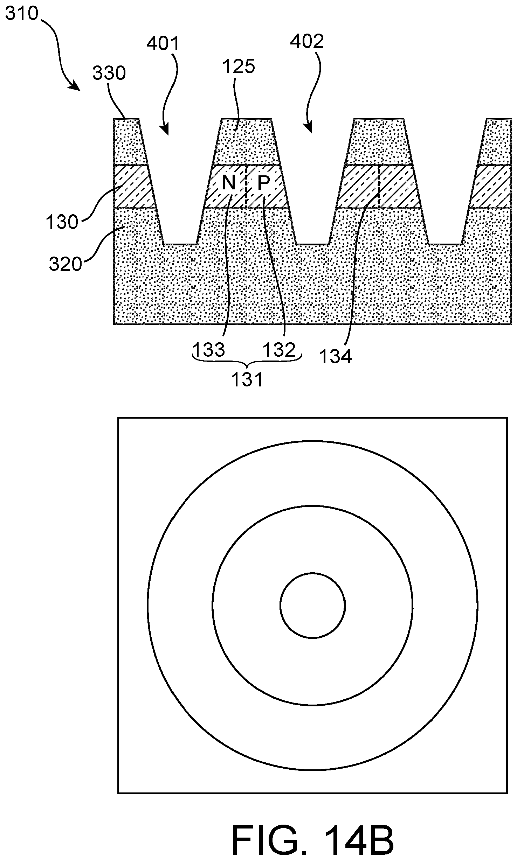

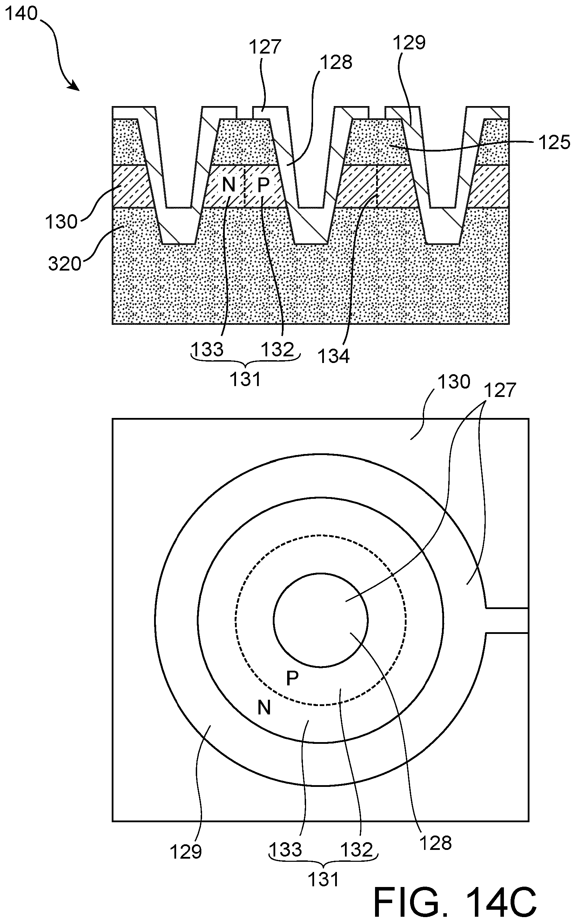

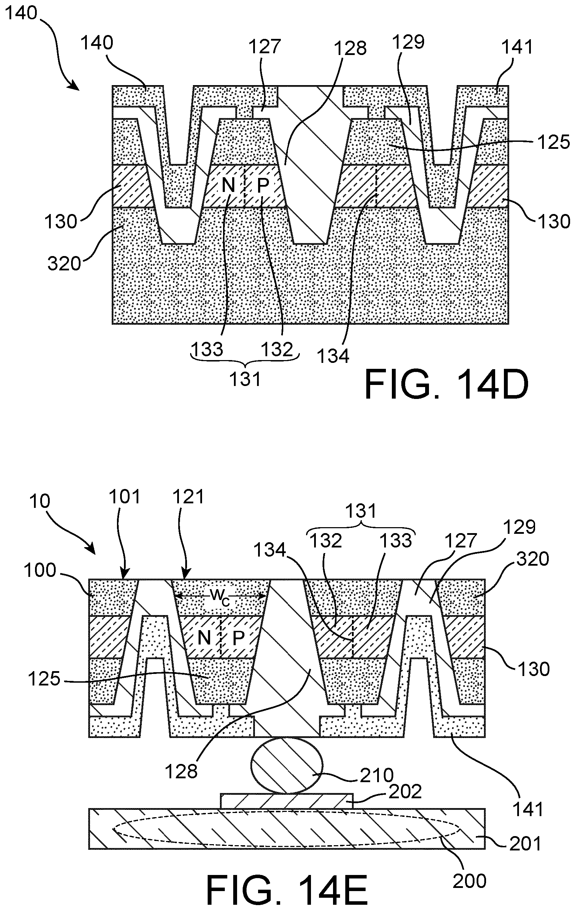

- les figures 14A à 14E illustrent les principales étapes de fabrication d'un procédé de fabrication d'une structure selon un quatrième mode de réalisation pratique de l'invention dans lequel la structure présente une conformation annulaire similaire à celle de la structure selon le deuxième mode de réalisation pratique et dans laquelle la structure est associée à un support de commande par hybridation par billes d'indium, les figures 14A, 14D et 14E montrant chacune une vue selon une coupe latérale et les figures 14B et 14C illustrant toutes deux une vue selon une coupe latérale et une vue de dessus,

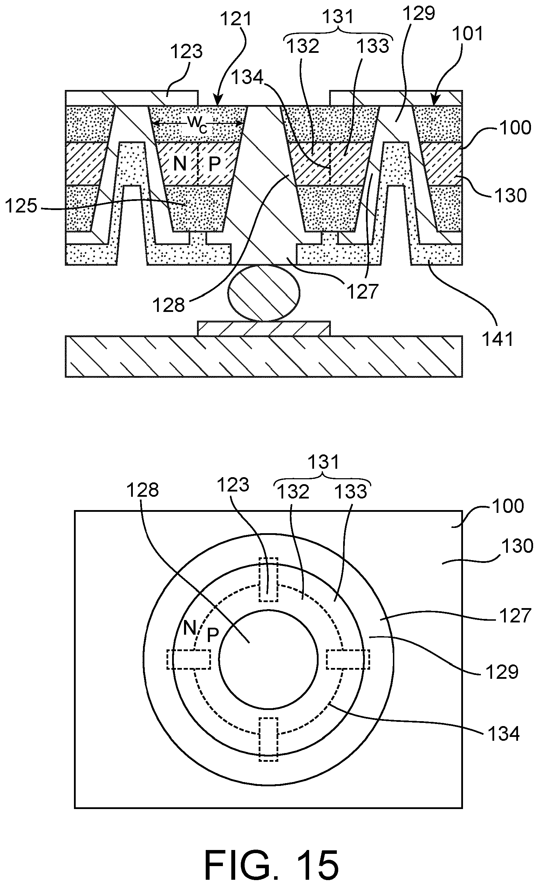

- la figure 15 illustre une variante de la structure selon le quatrième mode de réalisation dans laquelle il est prévu quatre extensions latérales sur une face de réception de la structure afin de limiter les éventuels modes électromagnétiques non désirés pour une telle structure, la figure 15 montrant une vue en coupe latérale et une vue de dessus d'une telle structure,

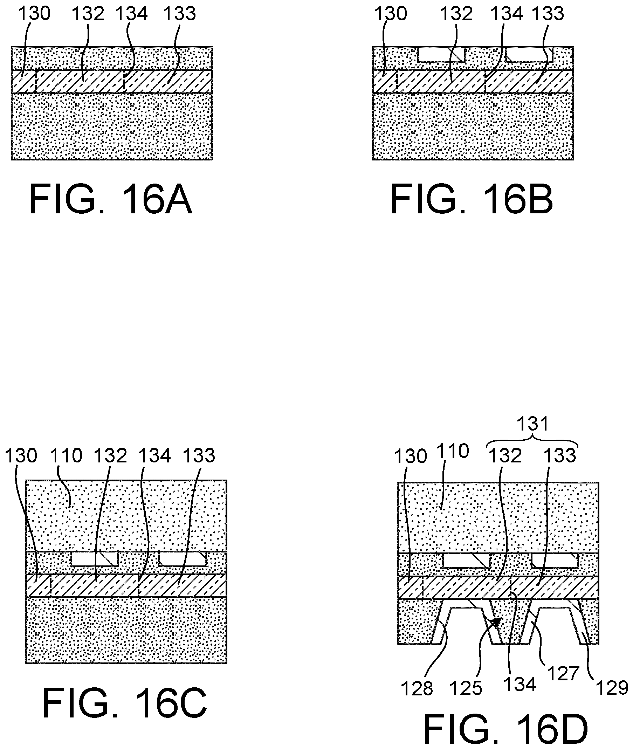

- les figures 16A à 16D illustrent au moyen de vues en coupe latérale les étapes principales de fabrication d'un procédé de fabrication d'une structure selon un cinquième mode de réalisation pratique de l'invention dans lequel le procédé est réalisé sans nécessiter une gravure traversante de la couche d'absorption,

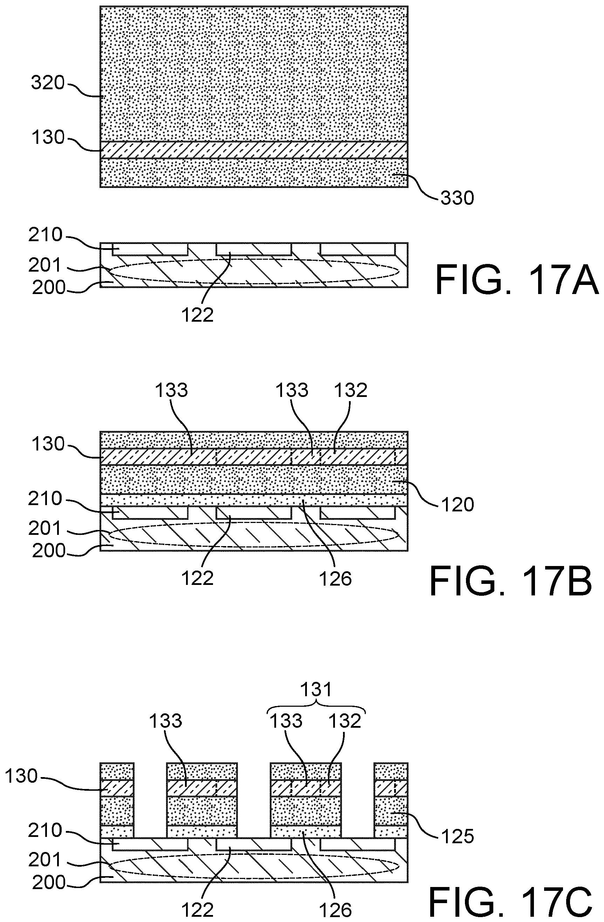

- les figure 17A à 17D illustrent au moyen de vues en coupe latérale les étapes principales de fabrication d'une structure selon un sixième mode de réalisation dans lequel la structure est associée à un support de commande par collage sur ledit support,

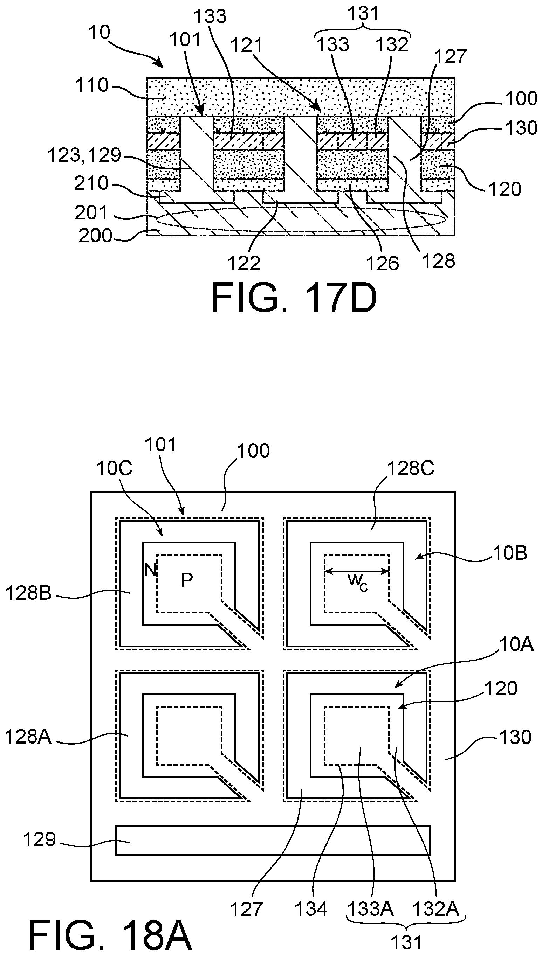

- les figures 18A à 18C illustrent par des vues de dessus des exemples de réalisation de l'invention autorisant un arrangement périodique optimisé de structures selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

On notera d'une manière générale dans le cadre de l'invention que par vue en coupe latérale et par vue en coupe transversale il est entendu, ci-dessus et dans le reste de ce document, une vue selon une coupe respectivement le long d'un plan perpendiculaire à un plan de la structure de détection correspondant généralement au plan de la couche d'absorption, et le long d'un plan parallèle audit plan de la structure de détection. Cette remarque s'applique de manière identique en ce qui concerne le terme section transverse.

## Exposé détaillé de modes de réalisation particuliers

La figure 2 illustre schématiquement une structure de détection 10 selon le principe de l'invention, une telle structure de détection 10 étant adaptée pour la détection d'un rayonnement électromagnétique dans au moins une première plage de longueurs d'onde donnée centrée autour d'une première longueur d'onde $\lambda 0$.

Une telle structure de détection 10 vise plus particulièrement la détection de rayonnements électromagnétiques dans la gamme de longueurs d'onde des infrarouges. Ainsi, les différentes valeurs indiquées dans les modes de réalisation décrits ci-après concernent cette application pratique, dans laquelle la gamme de longueurs d'onde visée est l'infrarouge moyen, c'est-à-dire entre 3 à 5 $\mu m$. Bien entendu, ces valeurs ne sont fournies qu'à titre d'exemple non limitatif, l'homme du métier étant parfaitement à même, à partir de la présente divulgation, d'adapter ces valeurs afin de permettre à l'aide d'une telle structure de détection 10 la détection optimisée de rayonnements électromagnétiques dans une gamme de longueurs d'onde autre que celle des infrarouges.

## Principe de l'invention

Une telle structure de détection 10 selon le principe de l'invention comporte :

- un milieu incident 110 par lequel la structure de détection reçoit le rayonnement électromagnétique, le milieu incident présentant un indice de réfraction $n_{ext}$,

- un support 100 présentant une face de réception 101 agencée pour recevoir au moins une partie du rayonnement électromagnétique transmise par le milieu incident 110, et dans lequel est aménagé une cavité Fabry-Perot 120 s'étendant au moins en partie le long d'une d'épaisseur dudit support, ladite cavité Fabry-Perot 120 débouchant sur une première ouverture 121 de ladite face de réception 101 et étant délimitée par au moins un milieu conducteur à permittivité négative 127 dudit support 100, la cavité Fabry-Perot 120 présentant, sur au moins une première partie de l'épaisseur du support 100 incluant la face de réception 101 et selon au moins une direction sensiblement parallèle à la face de réception 101, une longueur de cavité Fabry-Perot moyenne Wc, la cavité Fabry-Perot logeant au moins un premier milieu de confinement 125 d'indice de réfraction $n_d$ supérieure ou égal à l'indice de réfraction $n_{ext}$ du milieu incident,

- une région d'absorption 131 logée dans la cavité Fabry-Perot de telle façon que sa partie supérieure soit située à une distance h1 de la première ouverture comprise entre $\lambda_0/(50.n_d)$ et $\lambda_0/(4.n_d)$, la région d'absorption 131 étant configurée pour absorber le rayonnement électromagnétique et présentant un indice de réfraction $n_a$, présente une épaisseur $h_a$ inférieure à $\lambda_0/(5.n_a)$.

On notera que, dans une telle configuration de l'invention, milieu incident 110 est en amont du support 100, dans le sens propagation du rayonnement électromagnétique et que la partie de rayonnement électromagnétique reçue par le support et une partie transmise à partie dudit milieu de confinement. Qui plus est, dans la configuration, selon le principe de l'invention, le premier milieu de confinement 125 est intégralement contenu dans la cavité Fabry-Perot 120.

Dans une telle structure de détection 10, l'indice de réfraction $n_d$ de l'au moins un premier milieu de confinement est inférieur à 80% de l'indice de réfraction $n_a$ de la région d'absorption et l'au moins une longueur de cavité Fabry-Perot moyenne Wc est sensiblement égale à $\lambda_0/(2.n_{eff})$, avec $n_{eff}$ l'indice de réfraction effectif d'un mode guidé dans la région d'absorption 131 à la longueur d'onde $\lambda_0$.

On notera également que la structure de détection 10 illustrée sur la figure 2 présente une configuration selon une première possibilité de l'invention dans laquelle la cavité Fabry-Perot 120 est, à l'opposé de la première ouverture 121, fermée par une paroi réflectrice 122 configurée pour réfléchir le rayonnement électromagnétique ceci de manière à limiter les pertes radiatives sans perturbation du mode optique se propageant dans la cavité Fabry-Perot 120.

Bien entendu, le milieu incident 110 et le milieu de confinement 125 sont au moins en partie transparents, préférentiellement sensiblement transparents, dans la plage de longueurs d'onde à détecter.

En ce qui concerne le dimensionnement de la cavité Fabry-Perot 120 et, plus précisément, de la longueur de cavité Fabry-Perot moyenne Wc, conformément à la configuration de l'invention pour laquelle la région d'absorption présente une épaisseur $h_a$ significativement inférieure à la longueur d'onde $\lambda_0$ du rayonnement électromagnétique à absorber et dans laquelle la région d'absorption est entourée dans la cavité Fabry-Perot uniquement par le premier milieu de confinement 125, l'indice effectif $n_{eff}$ du mode guidé dans la région active 131 se propageant selon un plan sensiblement parallèle à la face de réception peut être estimé à partir de l'équation suivante :

$$n_{eff}^2 = n_d^2 \left[ 1 + \left( \left( \frac{n_a}{n_d} \right)^2 - 1 \right)^2 \left( \pi . \frac{h_a n_d}{\lambda_0} \right)^2 \right]$$

Avec $n_d$ l'indice de réfraction du milieu de confinement 125, $n_a$ l'indice de réfraction de la couche d'absorption 131, $h_a$ l'épaisseur de la couche d'absorption 131.

On notera qu'une telle équation, permettant d'estimer l'indice effectif d'un mode guidé dans la région d'absorption 131, a été déterminée pour un guide d'onde de configuration identique à celle de la région d'absorption et entouré, de part et d'autre, par le milieu de confinement.

Bien entendu, en variante, une telle valeur de l'indice effectif $n_{eff}$ peut être déterminée, conformément aux connaissances générales de l'homme du métier, au moyen de simulations numériques de routine.

Comme montré sur la figure 3, une telle structure de détection 10 présente une bonne sélectivité et un taux d'absorption particulièrement important.

La figure 3 qui représente graphiquement la variation du taux d'absorption (A) en fonction de la longueur d'onde ($\lambda$) du rayonnement électromagnétique pour une structure de détection 10 selon la configuration illustrée sur la figure 2 ceci en parallèle avec la variation du taux d'absorption (A) d'une couche d'absorption similaire à celle de ladite structure de détection 10 disposée à la surface d'une couche d'or Au. Ce taux d'absorption a été simulé par l'inventeur pour une structure 10 présentant la configuration suivante :

- de l'air en tant que milieu incident, l'indice de réfraction $n_{ext}$ dudit milieu incident 110 étant égal à 1,
- une température de fonctionnement de 77 K,
- une couche d'absorption 130 et une région d'absorption 131 en tellurure de mercure cadmium $Cd_x Hg_{1-x} Te$ avec x égale à 0,29, ce qui correspond à une largeur de bande interdire de 0,227 eV et un indice de réfraction de $n_a$ de 3,45, d'une épaisseur $h_a$ de 150 nm,
- une cavité Fabry-Perot 120 présentant une longueur de cavité Fabry-Perot de 1150 nm, avec une distance $h_1$ entre la première ouverture 121 et la couche d'absorption 130, comprenant la région d'absorption 131, étant égale à 350 nm et la distance $h_3$ entre la région d'absorption 131 et la paroi réflectrice 122 étant égale à 500 nm,

  - un premier milieu conducteur à permittivité négative 127 en or Au.

On peut ainsi voir sur la figure 3 qu'une telle structure de détection 10 présente un taux d'absorption 511 maximum de 91,5% à une longueur d'onde de 4 $\mu$m ceci avec une largeur à mi-hauteur allant de 3,5 $\mu$m à 4,3 $\mu$m. Ce résultat est à mettre en parallèle avec les taux d'absorption 503 obtenus pour une structure de détection de l'art antérieur montré sur la figure 2 et pour une couche d'absorption 130 similaire simplement disposée en contact avec une couche d'or Au qui fait alors office de miroir.

Selon le principe de l'invention, une structure de détection 10 de l'invention peut être formée au moyen d'un procédé de formation comprenant les étapes suivantes :

- fourniture d'une région d'absorption 131 avec une épaisseur inférieure à $\lambda_0/(5.n_a)$ , ladite région d'absorption présentant un indice de réfraction $n_a$ et étant associée avec au moins un milieu de confinement 125 d'indice de réfraction $n_d$ inférieur à 80% de l'indice de réfraction $n_a$ de la région d'absorption 120,
- formation d'une cavité Fabry-Perot 120 de manière à loger l'au moins un premier milieu de confinement 125, la cavité Fabry-Perot 120 s'étendant longitudinalement à partir d'au moins une première ouverture 121 et étant délimitée latéralement par au moins un premier milieu réflecteur conducteur 127 avec au moins une longueur de cavité Fabry-Perot moyenne Wc sensiblement égale à $\lambda_0/(2.n_{eff})$, avec un $n_{eff}$ un indice de réfraction effectif d'un mode guidé dans la région d'absorption à la longueur d'onde $\lambda_0$, ladite cavité Fabry-Perot logeant la région d'absorption à une distance $h_1$ de la première ouverture de ladite cavité comprise entre $\lambda_0/(50.n_d)$ et $\lambda_0/(4.n_d)$, voire entre $\lambda_0/(20.n_d)$ et $\lambda_0/(8.n_d)$, ladite formation de la cavité Fabry Perot permettant de former un support 100 présentant une face de réception 100 présentant la première ouverture 121 dans laquelle débouche la cavité Fabry Perot 120, la cavité Fabry-Perot 120 s'étendant au moins en partie le long d'une d'épaisseur dudit support 100 et présentant, sur au moins une première partie de l'épaisseur du support 100 incluant la face de réception 101 et selon au moins une direction sensiblement parallèle à la face de réception 101, une longueur de cavité Fabry-Perot moyenne Wc sensiblement égale à $\lambda_0/(2.n_{eff})$, avec $n_{eff}$ un indice de réfraction effectif d'un mode guidé dans la région d'absorption 131 à la longueur d'onde $\lambda_0$,
- formation d'un milieu incident 110 présentant un indice de réfraction $n_{ext}$ inférieur ou égal à l'indice de réfraction $n_d$ de l'au moins un milieu de confinement 125, le milieu incident 110 configuré pour recevoir le rayonnement électromagnétique et avec un agencement adapté pour que la face de réception 101 soit agencée pour recevoir au moins une partie du rayonnement électromagnétique transmise par le milieu incident 110.

Les figures 4A à 4C et 5A et 5B illustrent pour les figures 4A à 4C une structure de détection 10 selon la première possibilité conforme à la figure 3 et, pour les figures 5A et 5B, une structure de détection 10 selon une deuxième possibilité de l'invention. La deuxième possibilité de l'invention se différencie selon la première possibilité selon l'invention en ce que la cavité Fabry-Perot 120 présente, en lieu et place de la paroi réflectrice 122, et à l'opposé de la première ouverture, une deuxième ouverture.

Ainsi l'invention présente deux possibilités distinctes:

- une première possibilité, illustrée sur la figure 4A et conforme à la possibilité reprise sur la figure 2, dans laquelle la cavité Fabry-Perot 120 est munie, à l'opposé de la première ouverture, d'une paroi réflectrice 122,
- une deuxième possibilité, illustrée sur la figure 5A, dans laquelle la cavité Fabry-Perot 120, présente, à l'opposé de la première ouverture 12 , une deuxième ouverture 123.

Première possibilité de l'invention :

On notera également que la structure de détection 10 illustrée sur la figure 4A présente une configuration selon une première possibilité de l'invention dans laquelle la cavité Fabry-Perot 120 est, à l'opposé de la première ouverture 121, fermée par une paroi réflectrice 122 configurée pour réfléchir le rayonnement électromagnétique.

Selon cette première possibilité, comme illustré sur la figure 4A, la paroi réflectrice 122 est préférentiellement agencée à une distance $h_3$ de la région d'absorption qui est comprise entre $\lambda_0/(10.n_d)$ et $\lambda_0/(2.n_d)$, avec $n_d$ l'indice de réfraction premier milieu de confinement, ladite distance $h_3$ entre la paroi réflectrice 122 et la région d'absorption étant encore plus avantageusement comprise entre $\lambda_0/(7.n_d)$ et $\lambda_0/(4.n_d)$, la distance h3 étant de manière particulièrement avantageuse de l'ordre de voire sensiblement égale à, $\lambda_0/(5.n_d)$.

Ainsi, selon cette première possibilité de l'invention, la cavité Fabry-Perot s'étend sur une partie de l'épaisseur du support 100 qui est égale à la somme de la distance h1 entre la première ouverture 121 et la région d'absorption 131, de l'épaisseur $h_a$ de la région d'absorption et de la distance $h_3$ entre la région d'absorption 131 et la paroi réflectrice 122.

La figure 4B permet d'exemplifier une forme de la section transverse d'une structure de détection selon l'invention permettant d'optimiser la résonance Fabry-Perot. Selon cet exemple, la cavité Fabry-Perot 120 présente une section transverse carrée, le côté dudit carré correspondant à la longueur de cavité Fabry-Perot Wc. Bien entendu, comme cela est montré à la suite de ce document, d'autres formes de section transverse de la cavité Fabry-Perot 120 sont envisageables, telles que des sections annulaires ou circulaires, sans que l'on sorte du cadre de l'invention.

Afin de d'illustrer le phénomène de confinement du rayonnement électromagnétique permis par la configuration de l'invention, la figure 4C montre la cartographie du champ électrique le long d'une coupe latérale d'une structure de détections 10 ceci pour un rayonnement électromagnétique correspondant à longueur de résonance de la cavité Fabry-Perot, telle qu'illustrée sur la figure 4A. On peut ainsi voir que le couplage entre la cavité Fabry-Perot 120 et la région d'absorption 131 permet de confiner le rayonnement électromagnétique dans la région d'absorption 131.

Deuxième possibilité de l'invention :

Selon la deuxième possibilité de l'invention, illustrée sur la figure 5A, la cavité Fabry-Perot 120 de la structure de détection 10 comporte, à l'opposé de la première ouverture 121, une deuxième ouverture 123, la distance $h_2$ entre ladite deuxième ouverture 123 et la région d'absorption 131 étant supérieure à $\lambda_0/(2.n_d)$.

On notera que, d'une manière similaire à la structure de détection 10 selon la première possibilité, la cavité Fabry-Perot 120 de la structure de détection selon la deuxième possibilité de l'invention peut présenter une section transverse carrée, le côté dudit carré correspondant à la longueur de cavité Fabry-Perot Wc, d'autres formes de section transverse de la cavité Fabry-Perot 120 étant envisageables.

De même que pour la première possibilité de l'invention et la figure 4C, la figure 5B permet de montrer le phénomène de confinement du rayonnement électromagnétique permis par la configuration de l'invention. En effet, la figure 5B illustre une cartographie du champ électrique le long d'une coupe latérale d'une structure de détection 10 ceci pour un rayonnement électromagnétique correspondant à longueur de résonance de la cavité Fabry-Perot, telle qu'illustrée sur la figure 5A. On peut ainsi voir qu'avec une telle structure de détection le couplage entre la cavité Fabry-Perot 120 et la région d'absorption 131 permet de confiner le rayonnement électromagnétique dans la région d'absorption 131.

Qui plus est, que ce soit pour une structure selon la première possibilité ou pour une structure selon la deuxième possibilité, l'inventeur a également démontré que l'absorption du rayonnement électromagnétique pour une structure de détection 10 selon l'invention, qu'elle soit selon la première possibilité ou la deuxième possibilité, présente une faible dépendance en fonction de l'angle d'incidence du rayonnement électromagnétique. Ainsi la structure de détection 10 selon l'invention présente une acceptance angulaire particulièrement importante, ceci en raison que le principe de l'invention est basée sur l'exploitation d'une résonance localisée fournie par l'association d'un mode guide d'onde de la région d'absorption 131 et la cavité Fabry-Perot 120.

Ainsi, de manière à bénéficier d'une telle acceptance angulaire, il est envisageable, selon une possibilité non illustré de l'invention, de combiner une telle structure de détection 10 à un système de concentration de la lumière, telle qu'une lentille convergente.

Dimensionnement d'une structure selon l'invention

Afin de permettre l'identification des dimensions pertinentes dans le cadre de l'invention, l'inventeur a figuré la variation de l'absorption (A) d'une structure selon l'invention en fonction de certaines dimensions d'une structure selon l'invention.

Ainsi, la figure 6 illustre, dans le cadre d'une structure de détection 10 selon la première possibilité, la variation du taux d'absorption en fonction de la longueur d'onde du rayonnement électromagnétique à absorber ceci pour une distance h1 entre la première ouverture 121 et la région d'absorption 131 qui est respectivement égale à 0 nm (courbe 521), 50 nm (courbe 522), 150 nm (courbe 523), 300 nm (courbe 524) et 500 nm (courbe 525). On observe sur la figure 6 que pour une distance entre la première ouverture 121 et la région d'absorption 131 relativement faible, la résonance est peu marquée et le taux d'absorption est relativement faible. Ainsi, la courbe 521, par exemple, correspond à la configuration de l'art antérieur, telle que celle illustrée sur la figure 1. Par contre, dès que ladite distance $h_1$ augmente, comme illustré sur la figure 6, le taux d'absorption présente un pic plus marqué et donc plus sélectif comme cela est notamment montré par la courbe 523. Cependant, dès que la distance $h_1$ dépasse 300 nm, comme cela est montré sur la figure 6 par la courbe 525, on observe une baisse du taux d'absorption liée à de fortes fuites radiatives.

Ainsi, l'inventeur a identifié que cette distance $h_1$ de la première ouverture 121 de ladite cavité doit être comprise entre $\lambda_0/(50.n_d)$ et $\lambda_0/(4.n_d)$, voire entre $\lambda_0/(20.n_d)$ et $\lambda_0/(8.n_d)$, afin d'optimiser le taux d'absorption et la sélectivité en longueur d'onde d'une telle structure de détection. En conformité avec le principe de l'invention, l'ouverture de la cavité 120 est sub-longueur d'onde (la longueur de cavité moyenne Wc est inférieure à $\lambda_0/(2.n_d)$), ce qui implique une pénétration du rayonnement électromagnétique incident sous forme d'onde évanescente dans la cavité. Le couplage de cette onde avec la région d'absorption 131 doit donc être optimisé pour obtenir une résonance efficace, ce qui implique un ajustement de la distance $h_1$. Autrement dit, si $h_1$ est trop grande, la lumière évanescente n'arrive plus à atteindre la région d'absorption et si $h_1$ est trop faible, la structure présente de plus fortes fuites radiatives qui impactent négativement la qualité de la résonance.

Concernant le dimensionnement de la cavité Fabry-Perot, l'inventeur a également identifié que pour une configuration selon la deuxième possibilité de l'invention, comme le montre les graphiques sur la figure 7, la distance $h_2$ entre la région d'absorption 131 et la deuxième ouverture 123 devait être suffisante pour éviter les fuites radiatives du rayonnement électromagnétique par la deuxième ouverture 123 et ainsi piéger le rayonnement électromagnétique dans la région d'absorption 131.

En effet, la figure 7 illustre graphiquement le taux d'absorption en fonction de la longueur d'onde du rayonnement électromagnétique d'une structure de détection 10 selon la deuxième possibilité ceci pour une distance $h_2$ entre la région d'absorption 131 et la deuxième ouverture 123 respective de 500 nm (courbe 531), 1000 nm (courbe 532) et 2000 nm (courbe 533). Ainsi, on note que si pour une distance h2 de 500 nm le pic d'absorption n'atteint que 52% pour 500 nm, celui-ci atteint d'ores et déjà de 78% à 1000 nm et 88% à 2000 nm. Ainsi l'inventeur a pu identifier que pour la deuxième possibilité, une distance $h_2$ entre la région d'absorption 131 et la deuxième ouverture 123 supérieure à $\lambda_0/(2.n_d)$ permet de limiter significativement les fuites radiatives du rayonnement électromagnétique par la deuxième ouverture 123.

L'inventeur a également identifié un phénomène similaire pour la distance $h_3$ entre la région d'absorption 131 et la paroi réflectrice 122 en ce qui concerne la configuration selon la première possibilité de l'invention, à savoir la fermeture de la cavité par une paroi réflectrice 122. En effet, il a été observé que si la distance $h_3$ entre la région d'absorption 131 et la paroi réflectrice 122 devenait trop faible, la paroi réflectrice perturbait le mode guidé dans la région 131 et impliquait un fort décalage de la longueur d'onde de résonance vers les hautes fréquences, hors de la plage spectrale voulue. De même, pour une distance $h_3$ entre la région d'absorption 131 et la paroi réflectrice 122 trop importante, on perd le bénéfice du réflecteur qui permet de mieux concentrer la distribution de champ électrique sur la région 131.

Ainsi l'inventeur a pu identifier que pour la première possibilité, une distance $h_3$ entre la région d'absorption 131 et la paroi réflectrice 122 comprise entre $\lambda_0/(10.n_d)$ et $\lambda_0/(2.n_d)$, ladite distance $h_3$ entre la paroi réflectrice et la région d'absorption étant préférentiellement comprise entre $\lambda_0/(7.n_d)$ et $\lambda_0/(4.n_d)$ et étant de manière encore plus avantageuse sensiblement égale à $\lambda_0/(5.n_d)$.

Il est à noter que le principe de l'invention permet également comme cela est montré en lien avec les figures 8A à 8C, dans le cas où la région d'absorption 131 est comprise dans une couche d'absorption 130, de combiner deux cavités Fabry-Perot 120A, 120B, et les régions d'absorptions 131A, 131B, afin de fournir une structure de détection présentant une plage de longueurs d'onde de détection augmentée. Les figures 8A à 8C illustrent cette possibilité.

Selon cette possibilité, la structure de détection 10 est donc munie d'une couche d'absorption 120 dont deux parties, formant une première et une deuxième région d'absorption 131A, 131B sont logées respectivement dans une première et une deuxième cavité Fabry-Perot 120A, 120B. Selon cette possibilité, chacune de la première et la deuxième cavité Fabry-Perot 120A, 120B présente une longueur de cavité Fabry-Perot moyen $WC_A$, $WC_B$ qui lui est propre et donc une longueur d'onde de résonance qui lui est propre. De cette manière, comme le montre la figure 8A qui illustre, par la courbe 541, le taux d'absorption d'une telle structure de détection en fonction de la longueur d'onde du rayonnement électromagnétique à absorber, la première et la deuxième région d'absorption 131A, 131B permettent d'absorber le rayonnement électromagnétique dans une première et une deuxième plages de longueurs correspondant aux pics d'absorption présentés par la courbe 541. On peut en effet remarquer sur cette figure 8A que la courbe d'absorption 541 correspond à la somme des courbes d'absorption 542, 543 susceptibles d'être obtenues pour la première et la deuxième régions d'absorption 131A, 131B.

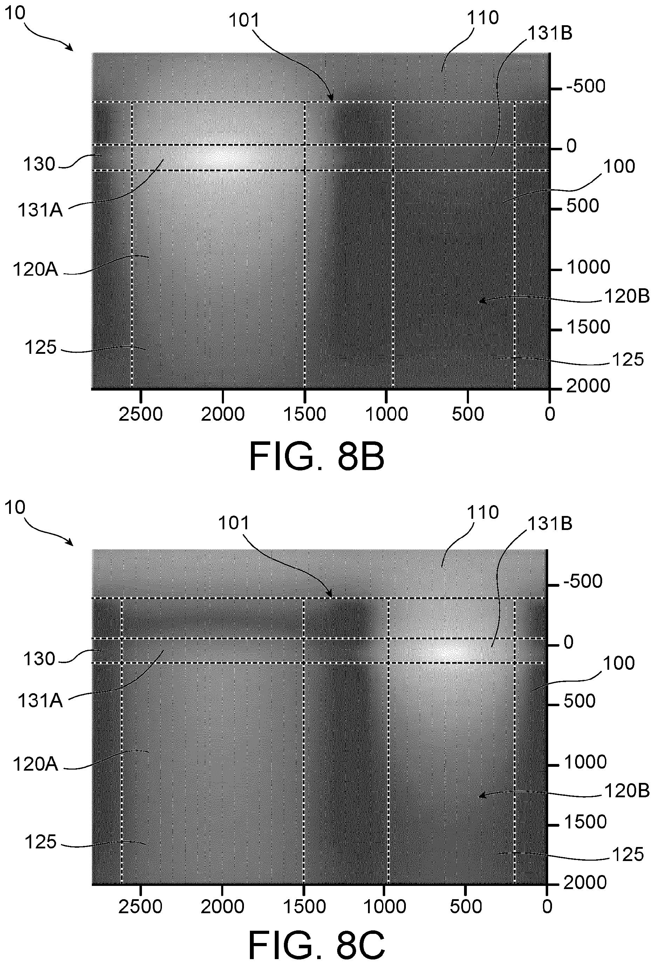

Ce phénomène de résonance multiple est montré sur les figures 8B et 8C qui montrent une cartographie du champ électromagnétique dans une structure selon l'invention pour respectivement un rayonnement électromagnétique correspondant à la longueur d'onde de résonance de la première cavité Fabry-Perot 120A et un rayonnement électromagnétique correspondant à la longueur d'onde de résonance de la première cavité Fabry-Perot 120B. On peut voir sur ces deux figures que, selon le principe de l'invention, pour un rayonnement électromagnétique correspondant à la longueur d'onde de résonance de la première cavité Fabry-Perot 120A, respectivement de la deuxième cavité Fabry-Perot 120B, le rayonnement électromagnétique se retrouve confiné dans la première région d'absorption 131A, respectivement dans la deuxième région d'absorption 131B, correspondant à ladite cavité Fabry-Perot, la deuxième région d'absorption 131B, respectivement la première région d'absorption 131A correspondant à l'autre cavité Fabry-Perot ne présentant pas de confinement particulier pour ledit rayonnement électromagnétique.

Ainsi, en conformité avec cette possibilité de l'invention, il est donc possible de fournir une structure de détection 10 selon l'invention présentant une plage de longueurs d'onde étendue au moyen d'une combinaison de plusieurs cavités de Fabry-Perot 120A, 120B et d'une couche d'absorption 130 interceptée par lesdites cavités de Fabry-Perot 120A, 120B.

## Variantes de l'invention

Les figure 9A à 9H illustrent un certain nombre de variantes d'une structure de détection 10 accessibles pour l'homme du métier dans le cadre la présente invention parmi lesquelles :

(i) la cavité Fabry-Perot présente sur une première partie d'épaisseur, comprise entre la première ouverture et la région d'absorption, la longueur de cavité Fabry-Perot Wc et, sur une deuxième partie d'épaisseur, qui s'étend au-delà de la région d'absorption 131, à l'opposé de la première ouverture 121, de dimension moyenne Wc' comprise entre 80% et 120% de la longueur de cavité Fabry-Perot Wc comme illustré sur la figure 9A,

(ii) la structure de détection 10 étant selon la première possibilité de l'invention, la paroi réfléchissante présente au moins une ouverture, la ou lesdites ouverture de la paroi réfléchissante possédant une dimension maximale qui est inférieure ou égale à la moitié de la dimension moyenne de confinement, soit Wc/2, comme illustré sur la figure 9B,

(iii) la structure de détection 10 comprend une couche d'absorption 130 logeant la région d'absorption 131, la couche d'absorption 130 étant discontinue pour ses parties en dehors de la cavité Fabry-Perot 120, comme illustré sur la figure 9B,

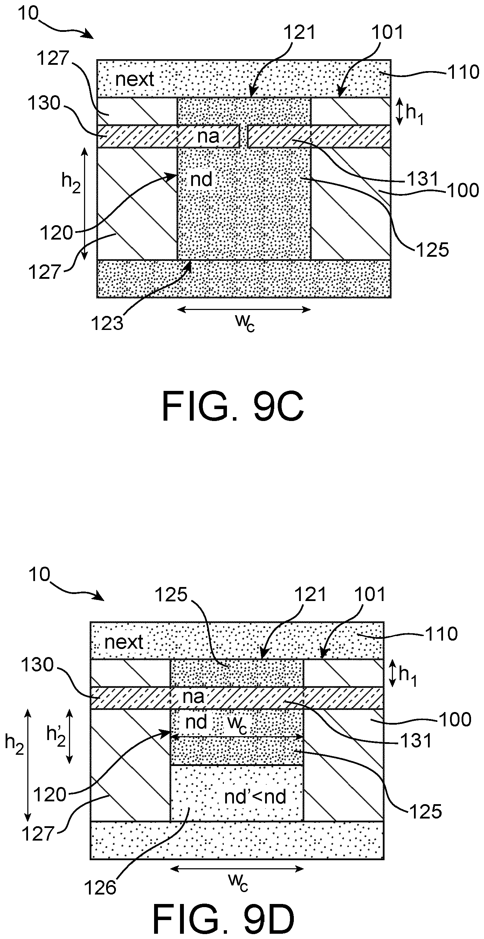

(iv) la région d'absorption 131 présente une ouverture traversante, ladite ouverture traversante présentant une dimension maximale selon le plan de couche de la région d'absorption inférieure ou égale à Wc/4 et étant préférentiellement placée au centre de la cavité Fabry-Perot en étant remplie du premier milieu de confinement 125, comme illustré sur la figure 9C,

(v) la structure de confinement comporte un deuxième milieu de confinement 126 logé dans la cavité Fabry-Perot à l'opposé de la première ouverture 121 avec le premier milieu de confinement 125 s'interposant entre la région d'absorption 131 et ledit deuxième milieu de confinement 126 qui présente un indice de réfraction $n_{d'}$ inférieur à l'indice de réfraction $n_d$ du premier milieu de confinement, comme illustré sur la figure 9D,

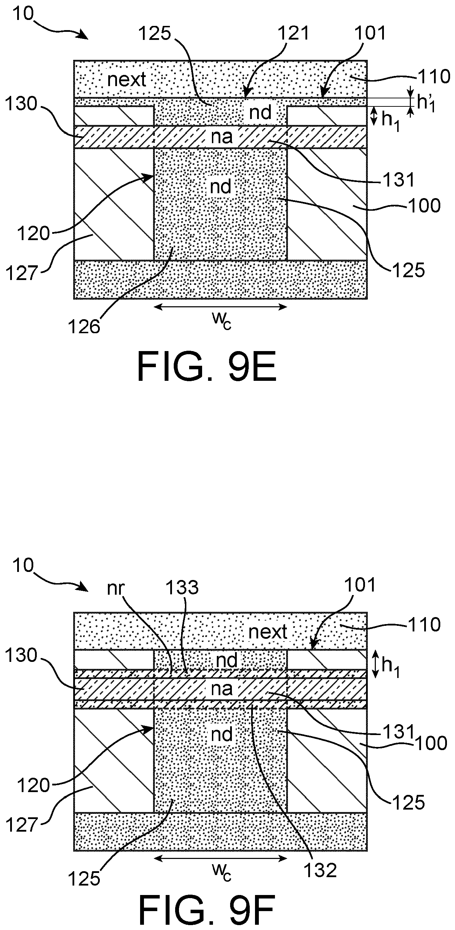

(vi) l'au moins un premier milieu de confinement 125 est en outre disposé à l'extérieur de la cavité Fabry-Perot 120, ledit premier milieu de confinement 125 formant, pour sa partie extérieure à la cavité Fabry-Perot 120 un revêtement du milieu réflecteur conducteur 127 d'une épaisseur $h_1'$ inférieure à la distance $h_1$ entre la première ouverture 121 et la région d'absorption 131, comme illustré sur la figure 9E,

(vii) la couche d'absorption 130 présente une couche d'adaptation 133 en regard de la première ouverture et/ou de la deuxième ouverture (ou, le cas échéant de la paroi réfléchissante), ladite couche d'adaptation 133 présentant un indice de réfraction $n_r$, préférentiellement variable, dont la valeur reste comprise entre l'indice de réfraction $n_d$ de l'au moins un milieu de confinement 125 et l'indice de réfraction $n_a$ de la couche d'absorption, comme illustré sur la figure 9F,

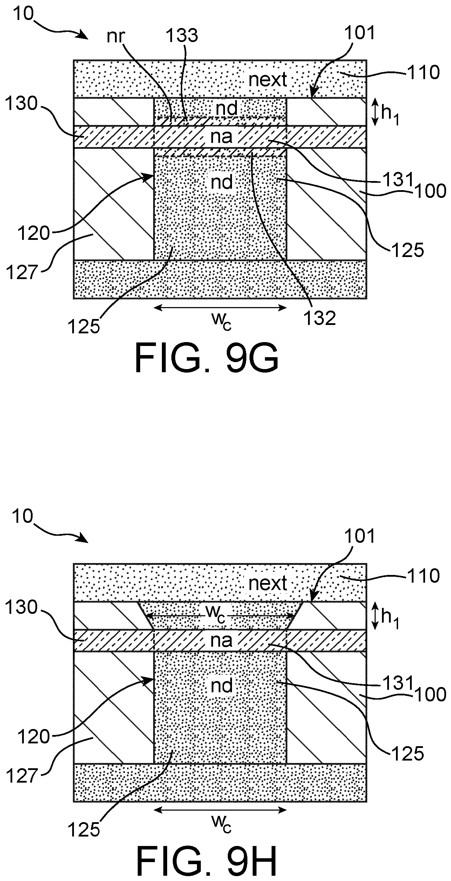

(viii) la région d'absorption 131 présente une couche d'adaptation en regard de la première ouverture et/ou de la deuxième ouverture (ou, le cas échéant de la paroi réfléchissante, ladite couche d'adaptation 133 présentant un indice de réfraction $n_r$, préférentiellement variable, dont la valeur reste comprise entre l'indice de réfraction $n_d$ de l'au moins un milieu de confinement 125 et l'indice de réfraction $n_a$ de la région d'absorption 131, le reste de la couche d'absorption 130 étant dénuée de la dite couche d'adaptation, comme illustré sur la figure 9G,

(ix) la cavité Fabry-Perot 120 présente, sur une première partie de sa hauteur, une section variable, dans le présent exemple une variation monotone, et donc une longueur de cavité Fabry-Perot variable, la longueur de cavité Fabry-Perot moyenne étant, selon le principe de l'invention, sensiblement égale à $\lambda_0/(2.n_{eff})$, comme illustré sur la figure 9H.

Concernant la variante (i) illustré sur la figure 9A, selon une possibilité préférentielle de ladite variante la portion centrale s'étend à partir de la région centrale jusqu'à la deuxième ouverture 123, dans le cas où la structure de détection 10 est selon la première possibilité, ou la paroi réfléchissante 122, dans le cas où la structure de détection 10 est selon la deuxième possibilité de l'invention.

Le principe de l'invention, en ce qui concerne notamment les première et deuxième possibilités de l'invention et des différentes variantes de configuration de cavité Fabry-Perot 120 et de la région d'absorption 131 ayant été décrit au travers des figures 2 à 9H, des modes de réalisation pratique de l'invention sont décrits ci-après.

## Modes de réalisation pratique de l'invention

### Premier mode de réalisation pratique de l'invention

Les figures 10A et 10B illustrent une structure de détection 10 selon un premier mode de réalisation pratique de l'invention dans laquelle la structure de détection 10 est basée sur une photodiode.

Une telle structure de détection 10, comme illustrée sur la figure 10A, est une structure de détection selon la deuxième possibilité de l'invention avec une section transverse carrée.

Dans ce premier mode de réalisation pratique de l'invention, la région d'absorption 131 comporte une première zone 132 dopée N et une deuxième zone 133 dopée P pour former une jonction semiconductrice 134. Ladite jonction semiconductrice 134 s'étend selon une diagonale de la section transverse carrée. De cette manière, la première et la deuxième zone 132, 133 représentent chacune la moitié du volume de la région d'absorption 131.

Afin de permettre la polarisation des première et deuxième zones 132, 133 indépendamment l'une de l'autre, le milieu conducteur 127 est divisé en un premier contact 128, formant un contact N de la structure de détection 10, et un deuxième contact 129, formant un contact P de la structure de détection 10, lesdits premier et deuxième contacts étant séparés l'un de l'autre par un ensemble de premier et deuxième bras de la couche d'absorption 130.

Ainsi, la région d'absorption 131, selon ce premier mode de réalisation pratique de l'invention, est logé dans une couche d'absorption 130 présentant, comme montré sur les figures 10B :

- le premier et le deuxième bras s'étendant au-delà de la région d'absorption 131 en passant au travers du milieu réflecteur conducteur 137 toute deux présentant une partie dopée N, en contact avec le premier contact 128, et une partie dopée P, en contact avec le deuxième contact 129, et

- une portion périphérique présentant un dopage P et qui entoure le milieu réflecteur conducteur 127 , ladite portion périphérique étant reliée à la région d'absorption au moyen des premier et deuxième bras.

Afin d'éviter un court-circuit entre le premier et le deuxième contact 128, 129, la portion périphérique de la couche d'absorption 130 comprend une partie dopée N permettant d'isoler le contact N du reste de la portion périphérique dopée P.

En ce qui concerne les matériaux des différents éléments de l'invention, l'homme du métier est apte à les choisir en fonction de la plage de longueurs d'onde visée à partir des conditions d'indice fourni dans le cadre de la description du principe de l'invention. Ainsi par exemple, dans le cas où la bande de longueurs d'onde du rayonnement électromagnétique à détecter par la structure de détection 10 est le moyen infrarouge, la structure de détection 10 peut présenter la configuration suivante :

- un milieu encapsulant en oxyde de silicium en tant que milieu incident, l'indice de réfraction $n_{ext}$ dudit milieu incident étant environ égal à 1,5,
- une température de fonctionnement de 77 K,
- une couche d'absorption 130 et une région d'absorption 131 en tellure de mercure cadmium $Cd_xHg_{1-x}Te$ avec x égale à 0,29, ce qui correspond à une largeur de bande interdire de 0,227 eV à 77K et un indice de réfraction $n_a$ de 3,45, celles-ci présentant une épaisseur $h_a$ de 150 nm,
- une cavité Fabry-Perot 120 présentant une dimension de confinement Wc de 900 nm, avec une distance $h_1$ entre la première ouverture 121 et la couche d'absorption 130, comprenant la région d'absorption 131, égale à 100 nm et la distance $h_3$ entre la région d'absorption 131 et la paroi réflectrice 122 égale à 300 nm,
- un premier milieu conducteur à permittivité négative 127 en or Au,
- un milieu de confinement d'indice $n_d$ réalisé en tellure cadmium CdTe qui est transparent dans la gamme de longueurs d'onde de l'infrarouge et qui présente un indice de réfraction de 2,7.

En ce qui concerne les premières et les deuxièmes zones 132, 133 de la couche d'absorption 131 celles-ci forment dans la couche d'absorption 131 une photodiode. Le dopage de la première zone 132 est un dopage N avec une concentration en porteur majoritaire préférentiellement comprise entre $10^{17}$ et $10^{18}$ cm$^{-3}$. Le dopage de la deuxième zone 133 est un dopage P avec une concentration en porteurs majoritaires préférentiellement comprise entre $10^{16}$ et $10^{17}$ cm$^3$

On notera que dans le cas d'une polarisation inverse à celle illustrée dans le présent mode de réalisation pratique de l'invention, c'est-à-dire une première zone 132 présentant un dopage P et une deuxième zone présentant un dopage N, la concentration en porteurs majoritaires de la première zone 132 est préférentiellement comprise entre $10^{17}$ et $10^{18}$ cm$^3$ et la concentration en porteurs majoritaires de la deuxième zone 133 est préférentiellement comprise entre $10^{15}$ et $5.10^{16}$ cm$^{-3}$.

Plus généralement, pour une plage de longueurs d'onde du rayonnement électromagnétique à détecter, en ce qui concerne le matériau de la couche d'absorption et donc de la région d'absorption, celui-ci peut être un tellurure de mercure cadmium $Cd_xHg_{1-x}Te$ avec une concentration en cadmium adaptée en fonction de la plage de longueurs d'onde choisi. Ainsi, pour des structures 10 adaptées pour recevoir un rayonnement électromagnétique dans la gamme des infrarouges courts inférieurs à 2 µm, la proportion en cadmium X peut être supérieure à 0,4. Pour des structures 10 adaptées pour recevoir un rayonnement électromagnétique dans la gamme des infrarouges lointains de l'ordre de 10 µm, la proportion en cadmium X peut être voisine de 0,3.

On notera également, en variante, le milieu réflecteur conducteur 127 peut être de l'argent Ag ou de l'aluminium Al.

Deuxième mode de réalisation pratique de l'invention

Les figures 11A et 11B illustrent un deuxième mode de réalisation pratique de l'invention dans lequel la cavité Fabry-Perot présente une section transverse annulaire. Une structure de détection selon ce deuxième mode de réalisation pratique de l'invention se différencie d'une structure selon le premier mode de réalisation pratique de l'invention en ce que :

- la cavité Fabry-Perot 120 est selon la première possibilité, la fermeture de cette dernière cavité n'étant que partielle, comme montré sur la figure 11A,
- la cavité Fabry-Perot 120 présente une section transverse annulaire, et
- le premier contact 128 et le deuxième contact 129 sont respectivement un contact périphérique et un contact central de la région d'absorption 131.

Ainsi, comme montré sur la figure 11A, la cavité Fabry-Perot 120 présente une section transverse annulaire, la dimension de confinement moyenne Wc correspondant à la différence de rayons entre une paroi extérieure et la paroi intérieure de la cavité Fabry-Perot 120. La première zone 132 de la région d'absorption 131 forme une moitié annulaire extérieure de la région d'absorption 131, la deuxième zone 133 de la région d'absorption 131 formant une moitié intérieure de la région d'absorption 131. La jonction semiconductrice s'étend donc selon un cercle interne de la cavité Fabry-Perot 131 et se présente selon une forme d'enveloppe cylindrique de révolution.

Le milieu conducteur à permittivité négative 127 comprend le premier contact 128 qui est périphérique à la cavité Fabry-Perot 120 et le deuxième contact 129 qui est central à la cavité Fabry-Perot. Le premier contact comprend, comme illustré sur la figure 11B, une ouverture afin d'autoriser le passage d'un deuxième via de connexion 129A du deuxième contact 129. On notera que le premier contact comprend également un premier via de connexion 128A du premier contact 128.

Selon un principe similaire à celui du premier mode de réalisation pratique de l'invention, dans l'ouverture du premier contact 128, la couche d'absorption 120 présente une partie dopée N, le long du premier contact, et une partie dopée P, le long du via de connexion 129A du deuxième contact 129.

D'une manière identique, la portion périphérique de la couche d'absorption 130 comprend une partie dopée N permettant d'isoler le premier contact 128, qui est un contact N, du reste de la portion périphérique dopée P.

Les figures 12A et 12B illustrent une variante de ce deuxième mode de réalisation pratique de l'invention, dans lequel :

- les première et deuxième zones 132, 133 de la région d'absorption 131 présentent un dopage inversé,
- le via de connexion 129A du deuxième contact 129 se trouve uniquement sur une portion haute de la cavité Fabry-Perot 120, ledit via de connexion 129A étant isolé de la première zone au moyen d'une couche isolante 140.

Ainsi, comme le montrent les figures 12A et 12B, le premier contact 128 est isolé du via de connexion 129A par la couche isolante 140 et en étant agencé en contact avec le milieu de confinement 125 qui est lui aussi un milieu diélectrique. De cette manière il n'est pas besoin de prévoir une zone dopée P autour du via de connexion 129A, ledit via de connexion 129A étant uniquement agencé en contact avec des matériaux isolants électriquement, le milieu de confinement 125 et la couche isolante 140.

Troisième mode de réalisation pratique de l'invention

La figure 13 illustre une structure selon un troisième mode de réalisation pratique de l'invention dans lequel la structure de détection 10 comporte une pluralité de cavités Fabry-Perot 120 connectées en parallèle ceci afin d'optimiser l'efficacité de la structure de détection 10. Une telle structure de détection 10 selon le troisième mode de réalisation pratique de l'invention se différencie d'une structure de détection 10 selon le premier mode de réalisation pratique de l'invention en ce que la structure de détection 10 comprend une pluralité de cavités de Fabry-Perot 120A, 120B, 120C et donc de régions d'absorption 131A, 131B, 131C, et en ce qu'elle comprend un premier contact 128 périphérique et un deuxième contact 129 central formant le milieu réflecteur conducteur 127.

Ainsi, comme le montre la figure 13, la structure 10 comprend huit cavités Fabry-Perot 120A, 120B, 120C, quatre cavités Fabry-Perot 120B de côté, en face d'un côté du deuxième contact 128 central de section carrée, et quatre cavités 120A, 120C d'angle, en correspondance avec un angle de du deuxième contact 129 central. Chaque cavité Fabry-Perot présente une section transverse carrée.

Dans chaque cavité Fabry-Perot 120A, 120B, 120C, selon une configuration similaire à celle du premier mode de réalisation pratique de l'invention, la première zone 132 représente la moitié de la région d'absorption et la deuxième zone 133 représente l'autre moitié de la région d'absorption avec la jonction semiconductrice qui s'étend selon une diagonale de section transverse de ladite cavité Fabry-Perot.

Ainsi avec une telle configuration, il est possible de bénéficier de l'absorption offerte par les huit cavités Fabry-Perot 120A, 120B, 120C tout en respectant les contraintes de dimensionnement de la cavité selon l'invention.

Quatrième mode de réalisation pratique de l'invention

Les figures 14A à 14E illustrent un procédé de fabrication d'une structure de détection 10 selon un quatrième mode de réalisation pratique de l'invention, un tel procédé permettant d'associer ladite structure de détection à un circuit de commande 200 fourni sur un deuxième support 201. Une telle structure de détection 10 se différencie, comme le montre la figure 14E, d'une structure de détection 10 selon le deuxième mode de réalisation pratique de l'invention en ce que :

- la première zone 132 et la deuxième zone 133 présentent une configuration inversée, la première zone 132 correspondant à la zone intérieure de la région d'absorption 131, la deuxième zone 133 correspondant à la zone extérieure de la région d'absorption 131,
- la cavité Fabry-Perot 120 présente une longueur de cavité Fabry-Perot Wc variable le long de sa hauteur, les parois de la cavité Fabry-Perot 120 présentant une pente,
- le deuxième contact 129, qui est le contact périphérique de la région d'absorption 131, est fermé et ne comporte pas d'ouverture pour le passage d'un quelconque via de connexion 210,
- le premier contact central 128 est adapté pour être connecté par hybridation par bille d'indium 210 au circuit de commande 200.

Ainsi, la région d'absorption 131, outre l'inversion de la configuration des première et deuxième zones 132, 133 et le fait que la cavité Fabry-Perot est dépourvue de via de connexion pour le contact central, ici le premier contact 128, présente une configuration similaire à celle de la structure de détection 10 selon le deuxième mode de réalisation pratique de l'invention.

Le procédé de fabrication d'une telle structure de détection 10 comporte les étapes suivantes :

- fourniture d'un premier support 310 comprenant un substrat 320, une couche d'absorption 130, ladite couche d'absorption 130 comprenant une première zone 132 dopée P et une deuxième zone 133 dopée N, pour former la région d'absorption 130, une couche de passivation 330, le substrat 320 et la couche de passivation 330 étant destinés à former le milieu de confinement 125 et la deuxième zone 133 entourant la première zone 132, comme illustré sur la figure 14A,

- gravure partielle et localisée du premier support 310 de manière à former dans la passivation 330, la couche d'absorption 130 et le substrat 320 l'empreinte des premier et deuxième contacts 128, 129, ladite gravure permettant de former une percée centrale 402, correspondant au deuxième contact 129, et une percée annulaire 401, entourant la percée centrale, correspondant au premier contact 128, ladite gravure partielle et localisée étant centrée autour de la première zone 132 de manière à positionner la jonction semiconductrice 134 entre lesdites première et deuxième percées 401, 402, comme illustré sur la figure 14B,

- dépôt localisé d'une couche de matériau conducteur réflecteur en contact des parois de la percée centrale et de la percée annulaire, le matériau conducteur réflecteur déposé en contact avec les parois de la percée centrale formant le premier contact 128 et le matériau conducteur réflecteur déposé en contact avec les parois de la percée périphérique formant le deuxième 129, ledit matériau réflecteur conducteur formant le milieu réflecteur conducteur 125, les premier et deuxième contacts étant espacés l'un de l'autre, comme illustré sur la figure 14C,
- dépôt d'un matériau isolant 140 sur la surface du premier support 310 autre que le premier contact 128,
- remplissage du reste de la percée centrale avec le matériau conducteur réflecteur 127 de manière à ce que le premier contact 128 est apte à autoriser une connexion par hybridation par bille d'indium 210, comme illustré sur la figure 14D,
- amincissement du substrat 320 afin de fournir une configuration conforme à la variante de la figure 9E, c'est-à-dire que l'épaisseur restante du support 320 en dehors de la cavité Fabry-Perot 120 présente une épaisseur $h_{1'}$ inférieure à la distance h1 entre la région d'absorption 131 et la première ouverture 121, comme illustré sur 14E.

La figure 15 illustre une structure de détection 10 selon une variante d'une structure de détection 10 selon ce troisième mode de réalisation pratique de l'invention qui se différencie en ce que le substrat 320 a été aminci de manière à libérer la première ouverture 121 et en ce qu'il est prévu des extensions latérales 123 du deuxième contact 129 au niveau de la première ouverture 121 de manière à limiter les modes électromagnétiques pouvant parasiter le mode de cavité Fabry-Perot lorsque la polarisation de la lumière incidente est mal orientée par rapport l'ouverture du résonateur annulaire.
De telles extensions latérales 123 peuvent, comme illustré sur la figure 15 à droite, prendre la forme de quatre portions de couche de matériau réflecteur conducteur réparties sur la périphérie du deuxième contact129.
Ainsi le procédé de fabrication d'une structure de détection 10 selon cette variante du troisième mode de réalisation pratique de l'invention se différencie d'un procédé de fabrication d'une structure de détection selon le troisième mode de réalisation pratique de l'invention en ce que :

- lors de l'étape d'amincissement du substrat 320, l'amincissement du substrat 320 est arrêté lorsque que la première ouverture 121 affleure la surface du substrat 320, et
- il est en outre prévu une étape de dépôt localisé de matériau réflecteur conducteur afin de former les extensions latérales 123 du deuxième contact 129.

Cinquième mode de réalisation pratique de l'invention

Les figures 16A à 16D illustrent les étapes d'un procédé de fabrication d'une structure de détection selon un cinquième mode de réalisation pratique de l'invention dans lequel la couche d'absorption 130 est continue et n'a donc pas été percée lors de la formation de ladite structure de détection 10. Une structure de détection 10 selon ce cinquième mode de réalisation se différencie d'une structure de détection 10 selon le premier mode de réalisation pratique de l'invention, en ce que la cavité Fabry-Perot 120 présente une dimension de confinement variable le long de sa hauteur, les parois de la cavité Fabry-Perot 120 présentant une pente.
Un procédé de fabrication d'une structure de détection 10 selon ce cinquième mode de réalisation comprend les étapes suivantes :

- fourniture d'un premier support 310 comprenant un substrat 320, une couche d'absorption 130, ladite couche d'absorption 130 comprenant une première zone 132 dopée P et une deuxième zone 133 dopée N, une couche de passivation 330, le substrat 320 et la couche de passivation 330 étant destinée à former le milieu de confinement 125, comme illustré sur la figure 16A,
- gravure partielle de la couche de passivation afin de former une première et une deuxième percée, correspondant respectivement au premier et au deuxième contact 128, 129, et entourant la jonction semiconductrice 134 entre la première et la deuxième zone 132, 133,
- dépôt d'un matériau réflecteur conducteur de manière à remplir la première et la deuxième percée, comme illustré sur la figure 16B,
- collage d'une couche en matériau isolant en contact de la couche de passivation 330 afin de former le milieu incident 110, comme illustré sur la figure 16C,

- gravure partielle et localisée du premier support 310 de manière à former dans le substrat 320 l'empreinte des premier et deuxième contacts 128, 129 outre les parties déjà formées dans la couche de passivation 330, ladite gravure permettant de former une troisième percée, correspondant au premier contact 128, et une quatrième percée, correspondant au deuxième contact 129, les deux percées pénétrant au moins partiellement les zones 132 et 133 respectivement,

- dépôt localisé d'une couche du matériau conducteur réflecteur en contact des parois de la troisième percée et de la quatrième contact, le matériau conducteur réflecteur déposé en contact avec les parois de la percée centrale formant le premier contact 128 et le matériau conducteur réflecteur déposé en contact avec les parois de la percée périphérique formant le deuxième 129, ledit matériau réflecteur conducteur formant le milieu réflecteur conducteur 127, les premier et deuxième contacts étant espacés l'un de l'autre, comme illustré sur la figure 16D.

### Sixième mode de réalisation pratique de l'invention

Les figures 17A à 17D illustrent une structure de détection 10 selon un sixième mode de réalisation pratique de l'invention dans lequel la structure détection 10 est collée à un deuxième support 201 afin de la connecter à circuit de commande 200 dudit deuxième support 201.

On notera que dans ce sixième_mode de réalisation, la structure de détection 10 est selon la première possibilité de l'invention avec la cavité Fabry-Perot partiellement fermée par des plots de contact 210 du deuxième support 201, lesdits plots de contact formant la paroi réflectrice 122. Si les figures 17A à 17D montrent uniquement une coupe latérale de la structure de détection, la cavité de Fabry-Perot peut présenter une section transverse carrée, ladite cavité présentant une ouverture pour permettre une polarisation de la deuxième zone 133 au moyen du deuxième contact 123 qui est un contact commun. Chaque plot isolé 127 est environné d'une zone 132 d'un premier type de dopage, deux zones 132 adjacentes étant complètement séparées par une zone 133 d'un autre type de dopage. Toutes les zones 133 forment entre elles une région contiguë et connexe électriquement (continue et de même type de dopage) et sont en contact commun direct avec un plot latéral 123.

Un procédé de fabrication d'une structure de détection 10 selon ce quatrième mode de réalisation comprend les étapes suivantes :

- fourniture d'un premier support 310 comprenant un substrat 320, une couche d'absorption 130, ladite couche d'absorption 130 étant dopée P, le substrat 320 et la couche de passivation 330 étant destinée à former le milieu de confinement 125,

- fourniture d'un deuxième support 200, ledit deuxième support 200 comprenant un circuit de commande 200 de la structure de détection et des plots de contact 210 configurés pour être connectés à des contacts de la structure de détection 10 et pour former une paroi réflectrice 122 selon l'invention, comme illustré sur la figure 17A,

- collage du premier support 310 au deuxième support avec la couche de passivation 330 en contact avec la surface du deuxième support 201 qui comprend les plots de contact 210, ledit collage étant réalisé avec un matériau apte à former un deuxième milieu de confinement 126, conformément à la variante (v) de l'invention, ledit matériau apte à former le deuxième milieu de confinement 126 peut être, par exemple, une résine époxyde non conductrice,

- amincissement du substrat 320, comme illustré sur la figure 17B,

- dopage de la couche d'absorption 130 par implantation d'élément de dopant apte à fournir des électrons en tant que porteurs majoritaires ceci de manière à permettre de former la première zone 133 et délimiter la deuxième zone 132,

- gravure localisée du substrat 320, de la couche d'absorption 130, la passivation 330 et le matériau apte à former le deuxième milieu de confinement 126 afin de former les empreintes des premier et deuxième contact, lesdites empreintes débouchant sur les plots de contact 210 du deuxième support 201, comme illustré sur la figure 17C,

- remplissage des empreintes par le milieu réflecteur conducteur 127 de manière à former les premier et deuxième contacts 122, 123, comme illustré sur la figure 17D.

### Possibilités d'association de plusieurs structures de détection selon l'invention

Les figures 18A à 18C présentent différents agencements de structures de détection selon l'invention ceci de manière à fournir un dispositif de détection 1 de rayonnement électronique comprenant une pluralité desdites structures de détections 10A, 10B, 10C associées entre elles. De tels dispositifs de détection 1 comportent, comme illustré sur la figure 18A, la pluralité de structures de détection 10A, 10B, 10C, chacune présentant, une cavité Fabry-Perot 120, une région d'absorption 131, un premier contact individuel 128A, 128B, 128C, le dispositif détection comportant en outre un deuxième contact 129 commun.

Selon la première possibilité d'agencement d'un tel dispositif 1 illustré sur la figure 18A, la cavité Fabry-Perot 120 de chaque structure de détection 10A, 10B, 10C présente une section transverse carrée, la première zone 132 étant une zone périphérique de la région d'absorption 131 et la deuxième zone 133 étant centrale avec une jonction semiconductrice 134 présentant une section transverse carrée. Selon cette même possibilité, le milieu réflecteur conducteur est formé par le premier contact 128A, 128B, 128C. Le premier contact 128A, 128B, 128C de chaque structure de détection 10A, 10B, 10C présente une ouverture afin de permettre une polarisation de la deuxième zone 133. La couche d'absorption 130 est en outre munie du deuxième contact 129 commun. De cette manière, il est possible, avec un tel agencement de polariser individuellement chaque structure de détection, et donc détecter le courant de fonctionnement individuel de ladite structure de détection 10 tout en présentant un agencement compact.

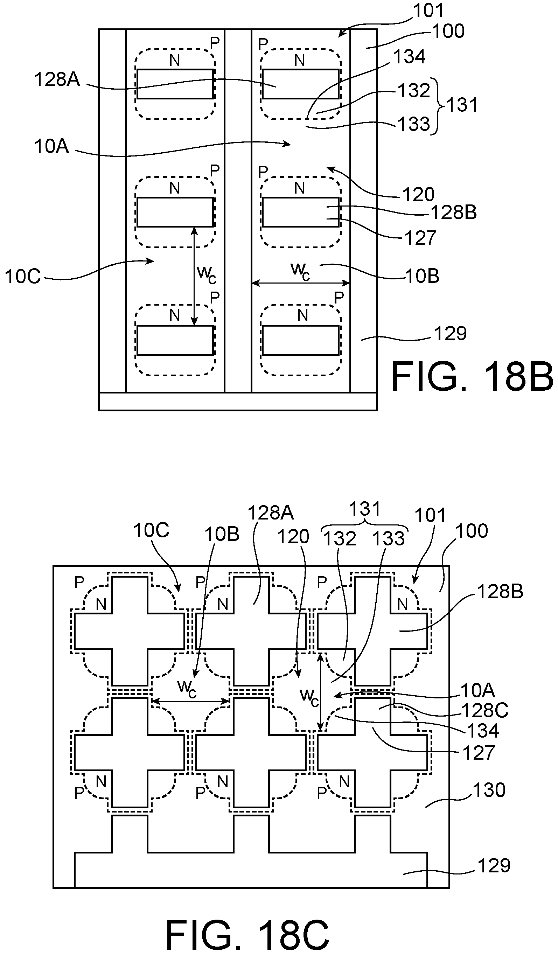

Selon la deuxième possibilité d'agencement d'un tel dispositif 1 illustré sur la figure 18B, les premier contacts 128A, 128B présentent une section transverse rectangulaire délimitant de part et d'autre chacune des cavités Fabry-Perot, chacune des cavités Fabry-Perot étant en outre limitée latéralement par deux extensions du deuxième contact 129. Pour chacune des structures de détection 10A, 10B, 10C, la première zone 132 entoure les premiers contacts 128A, 128B délimitant la cavité Fabry-Perot 120, le reste de la région d'absorption formant la deuxième zone 133 de ladite structure de détection 10A, 10B, 10C.

Selon la troisième possibilité d'agencement d'un tel dispositif 1 illustré sur la figure 18C, chacune des cavités Fabry-Perot 120 est délimitée par quatre premiers contacts 128A, 128B, 128C de manière qu'elles présentent une section transverse carrée. Chaque premier contact 128A, 128B, 128C présentent une section transverse en croix, les bras desdits premiers contacts 128A, 128B, 128C formant les parois de la cavité Fabry-Perot 120. La première zone 132 de chaque région d'absorption 131 entoure lesdits premiers contacts 128A, 128B, 128C.

Bien entendu, conformément aux connaissances de l'homme du métier, si dans les modes de réalisation pratique de l'invention décrits dans le présent document la première zone 132 de la région d'absorption 131 présente un dopage particulier, la deuxième zone 133 de la région d'absorption présentant un dopage opposé, il est également envisageable, sans que l'on sorte du cadre de l'invention, d'inverser les différents dopages de la structure selon chacun desdits modes de réalisation pratique de l'invention. Autrement dit et d'une manière générale, dans chacun desdits modes de réalisation pratique de l'invention, la première zone 132 de la région d'absorption 131 présente un premier type de conductivité sélectionné parmi le type de conductivité dans lequel les électrons sont les porteurs majoritaires et le type de conductivité dans lequel les trous sont les porteurs majoritaires, la deuxième zone 133 de la région d'absorption 131 présentant un deuxième type de conductivité opposé au premier type de conductivité.

On notera également que, selon une possibilité avantageuse de l'invention, comme cela a déjà été décrit, qu'une structure de détection 10 selon l'invention peut être équipée d'un dispositif optique de concentration de rayonnement électromagnétique, tel qu'une lentille ou un miroir, configuré pour concentrer une partie du rayonnement électromagnétique sur la première ouverture 121 de la cavité Fabry-Perot de la structure de détection 10. On notera qu'une telle fonction de dispositif optique de concentration peut éventuellement être fourni par une conformation du milieu incident, celui-ci pouvant présenter un profil lentillaire ou pluri-lentillaire de forme convexe sur la face exposée à la lumière incidente.

Bien entendu, l'ensemble des modes de réalisation pratique de l'invention sont fournis qu'à titre d'exemple de réalisation de l'invention et l'homme du métier est à même de les adapter en fonction de ces besoins particuliers, notamment pour optimiser son fonctionnement à une première plage de longueur d'onde particulière, sans que l'on sorte du cadre de l'invention. En particulier, les formes de jonction semiconductrice décrites en lien avec ces différents modes de réalisation pratique ne sont nullement limitatives et peuvent aisément être modifiées par un homme du métier. Selon ce même principe, si dans les présents modes de réalisation pratique de l'invention la région d'absorption 131 est du type photodiode en présentant une première et une deuxième zone 132, 133 de dopage inversé, les jonctions de diodes peuvent être absentes et dans ce cas, le détecteur est plus utilisé comme photo-conducteur, c'est-dire basé sur le passage du courant entre contacts par effet purement photo-résistif à travers le semi-conducteur, comme dans les bolomètres.

Il convient de noter que toutes les structures de diodes 10 exposées précédemment sont employées comme détecteur (absorbeur) de rayonnement électromagnétique dans l'invention, mais elles pourraient tout aussi bien, réciproquement, être utilisées somme émetteurs de rayonnement, en injectant du courant dans les jonctions de diodes.

## Revendications

1. Structure de détection (10) de rayonnements électromagnétiques adaptée pour détecter un rayonnement électromagnétique dans au moins une première plage de longueurs d'onde donnée centrée autour d'une première longueur d'onde $\lambda_0$, la structure de détection (10) comprenant :

   - un support (100) présentant une face de réception (101) agencée pour recevoir au moins une partie du rayonnement électromagnétique, et dans lequel est aménagée une cavité Fabry-Perot (120) s'étendant au moins en partie le long d'une d'épaisseur dudit support, ladite cavité Fabry-Perot (120) débouchant sur une première ouverture (121) de ladite face de réception (101) et étant délimitée par au moins un milieu conducteur à permittivité négative (127) dudit support (100), la cavité Fabry-Perot (120) présentant, sur au moins une première partie de l'épaisseur du support (100) incluant la face de réception (101) et selon au moins une direction sensiblement parallèle à la face de réception (101), une longueur de cavité Fabry-Perot moyenne Wc, la cavité Fabry-Perot logeant au moins un premier milieu de confinement (125) d'indice de réfraction $n_d$,

- une région d'absorption (131), configurée pour absorber le rayonnement électromagnétique, la région d'absorption (131) présentant un indice de réfraction $n_a$,
- la longueur de cavité Fabry-Perot moyenne Wc étant sensiblement égale à $\lambda_0/(2.n_{eff})$, avec $n_{eff}$ un indice de réfraction effectif d'un mode guidé dans la région d'absorption (131) à la première longueur d'onde $\lambda_0$,

la structure de détection (10) étant **caractérisée en ce que**

- la région d'absorption présente une épaisseur $h_a$ inférieure à $\lambda_0/(5.n_a)$,
- la région d'absorption (131) est logée dans la cavité Fabry-Perot à une distance $h_1$ de la première ouverture (121) de ladite cavité Fabry-Perot comprise entre $\lambda_0/(50.n_d)$ et $\lambda_0/(4.n_d)$,
- l'épaisseur de l'au moins une première partie étant égale ou supérieure à hi,
- l'indice de réfraction $n_d$ de l'au moins un premier milieu de confinement étant inférieur à 80% de l'indice de réfraction $n_a$ de la région d'absorption.

2. Structure de détection selon la revendication 1, dans laquelle la cavité Fabry-Perot présente sur une deuxième partie de l'épaisseur du support au moins une dimension selon au moins une direction sensiblement parallèle à la face de réception (101) comprise entre 80% et 120% de la longueur de cavité Fabry-Perot moyenne Wc.

3. Structure de détection (10) selon la revendication 1 ou 2, dans lequel la région d'absorption (130) est aménagée dans une couche d'absorption (131), ladite couche d'absorption (131) s'étendant en dehors de la cavité Fabry-Perot (120) selon un plan sensiblement parallèle à la face de réception (101).

4. Structure de détection (10) selon l'une quelconque des revendications 1 à 3, dans laquelle la cavité Fabry-Perot (120) est, à l'opposé de la première ouverture, au moins en partie fermée par une paroi réflectrice (122) configurée pour réfléchir le rayonnement électromagnétique, ladite paroi réflectrice (122) étant agencée à une distance $h_3$ de la région d'absorption qui est comprise entre $\lambda_0/(10.n_d)$ et $\lambda_0/(2.n_d)$, avec $n_d$ l'indice de réfraction du premier milieu de confinement, ladite distance $h_3$ entre la paroi réflectrice (122) et la région d'absorption étant préférentiellement comprise entre $\lambda_0/(7.n_d)$ et $\lambda_0/(4.n_d)$ et avantageusement sensiblement égale $\lambda_0/(5.n_d)$.

5. Structure de détection (10) selon l'une quelconque des revendications 1 à 3, dans laquelle, la cavité Fabry-Perot (120) présente, à l'opposé de la première ouverture (121), une deuxième ouverture, la distance $h_2$ entre ladite deuxième ouverture et la région d'absorption étant supérieure à $\lambda_0/(2.n_d)$.

6. Structure de détection (10) selon l'une quelconque des revendications 1 à 5, dans laquelle la structure de détection (10) comprend au moins une couche d'adaptation d'indice de réfraction $n_r$ disposée entre la région d'absorption (131) et le milieu de confinement (125), ladite couche d'adaptation d'indice de réfraction présentant un indice de réfraction dont la valeur reste comprise entre l'indice de réfraction $n_d$ de l'au moins un milieu de confinement et l'indice de réfraction $n_a$ de la couche d'absorption en diminuant de la région d'absorption (131) vers le milieu de confinement (125).

7. Structure de détection (10) selon l'une quelconque des revendications 1 à 6 comprenant un deuxième milieu de confinement, ledit deuxième milieu de confinement étant logé dans la cavité Fabry-Perot à l'opposé de la première ouverture avec le premier milieu de confinement s'interposant entre la région d'absorption et ledit deuxième milieu de confinement, le deuxième milieu de confinement présentant un indice de réfraction $n_{d'}$ inférieur à l'indice de réfraction $n_d$ du premier milieu de confinement.

8. Structure de détection (10) selon l'une quelconque des revendications 1 à 7, l'au moins un premier milieu de confinement (125) est en outre disposé à l'extérieur de la cavité Fabry Perot (125), ledit premier milieu de confinement (125) formant, pour sa partie extérieure à la cavité Fabry-Perot (120), un revêtement du milieu conducteur à permittivité négative (127) d'une épaisseur $h_{1'}$ inférieure à $h_1$.

9. Structure de détection (10) selon l'une quelconque des revendications 1 à 7 comprenant en outre un milieu incident (110) amont du support (100), dans le sens propagation du rayonnement électromagnétique, le milieu incident (110) étant configuré pour recevoir le rayonnement électromagnétique et le transmettre au support , le milieu incident (110) présentant un indice de réfraction $n_{ext}$ inférieur ou égale à l'indice de réfraction $n_d$ du premier milieu de confinement (125),

dans lequel le premier milieu de confinement (125) est intégralement contenu dans la cavité Fabry-Perot (120).

**10.** Dispositif de détection de rayonnements électromagnétiques comprenant une pluralité de structures de détection (10) selon l'une quelconque des revendications 1 à 9, chacune des structures de détection (10) étant adaptée pour détecter un rayonnement électromagnétique dans l'au moins une première plage de longueurs d'onde donnée centrée autour de la première longueur d'onde $\lambda_0$, lesdites structures de détection (10) étant agencées périodiquement avec une périodicité inférieure à $\lambda_0/n_{ext}$ où $n_{ext}$ est l'indice de réfraction d'un milieu incident (110) amont du support (100), dans le sens propagation du rayonnement électromagnétique, et de préférence inférieure à 75% de $\lambda_0/n_{ext}$.

**11.** Procédé de fabrication d'une structure de détection (10) de rayonnements électromagnétiques adaptée pour détecter un rayonnement électromagnétique dans au moins une première plage de longueurs d'onde donnée centrée autour d'une première longueur d'onde $\lambda_0$, le procédé de fabrication comprenant les étapes suivantes :

- fourniture d'une région d'absorption (131) d'une épaisseur $h_a$ inférieure à $\lambda_0/(5.n_a)$ , ladite région d'absorption (131) présentant un indice de réfraction $n_a$ et étant associée avec au moins un milieu de confinement (125) d'indice de réfraction $n_d$ inférieur à 80% de l'indice de réfraction $n_a$ de la région d'absorption (131),),
- formation d'une cavité Fabry-Perot (120) de manière à y loger au moins en partie l'au moins un premier milieu de confinement (125) et la région d'absorption (131), la cavité Fabry-Perot (120) étant délimitée latéralement par au moins un premier milieu conducteur à permittivité négative (127) avec un $n_{eff}$ un indice de réfraction effectif d'un mode guidé dans la région d'absorption (131) à la longueur d'onde $\lambda_0$, ladite cavité Fabry-Perot (120) logeant la région d'absorption (131) à une distance $h_1$ de la première ouverture (121) de ladite cavité Fabry-Perot (120) comprise entre $\lambda_0/(50.n_d)$ et $\lambda_0/(4.n_d)$, , ladite formation de la cavité Fabry Perot permettant de former un support (100) présentant une face de réception (101) présentant la première ouverture (121) dans laquelle débouche la cavité Fabry Perrot (120), la cavité Fabry-Perot (120) s'étendant au moins en partie le long d'une d'épaisseur dudit support (100) et présentant, sur au moins une première partie de l'épaisseur du support (100) incluant la face de réception (101) et selon au moins une direction sensiblement parallèle à la face de réception (101), une longueur de cavité Fabry-Perot moyenne Wc sensiblement égale à $\lambda_0/(2.n_{eff})$, avec $n_{eff}$ un indice de réfraction effectif d'un mode guidé dans la région d'absorption (131) à la longueur d'onde $\lambda_0$.

**12.** Procédé de fabrication d'une structure de détection (10) selon la revendication 11, dans lequel lors de l'étape de fourniture de la région d'absorption (131), il est fourni le support (310) comprenant un substrat (320), une couche d'absorption (130) et une couche de passivation se succédant, au moins l'un du substrat et de la couche de passivation étant destiné à former l'au moins un milieu de confinement, l'étape de formation d'une cavité Fabry-Perot (120) comprenant les sous-étapes suivantes de :

- gravure localisée du support (310) de manière à former au moins une première percée correspondant au milieu conducteur à permittivité négative, l'au moins une percée délimitant une cavité logeant au moins en partie le milieu de confinement (125) et la région d'absorption (131),
- remplissage de l'au moins une percée par le matériau du milieu conducteur à permittivité négative (127) de manière à former ledit milieu conducteur à permittivité négative (127) et donc la cavité Fabry-Perot (120).

**13.** Procédé de fabrication selon la revendication 11 ou 12, dans lequel il est en outre prévu les étapes de :

- fourniture d'un deuxième support (201) comprenant un circuit de commande (200), ledit circuit de commande (200) présentant au moins un plot de contact,
- connexion de la structure de détection au circuit de commande par hybridation par bille d'indium du milieu réflecteur conducteur (127) au premier plot de contact.

**14.** Procédé de fabrication selon la revendication 12, dans lequel il est prévu, préalablement à l'étape de gravure localisée, les étapes suivantes :

- fourniture d'un deuxième support (201) comprenant un circuit de commande (200), ledit circuit de commande (200) présentant au moins un plot de contact,
- collage du premier support (310) sur une face du premier support (200) comprenant l'au moins un plot de contact,

dans lequel lors de la sous-étape de gravure localisé, l'au moins une percée débouche sur le plot de contact, de telle manière que lors de la sous-étape remplissage de l'au moins une percée, le matériau conducteur à permittivité négative (127) est également déposé en contact de l'au moins un plot de contact.

**Patentansprüche**

1. Detektionsstruktur (10) für elektromagnetische Strahlungen, die dazu ausgelegt ist, eine elektromagnetische Strahlung in wenigstens einem ersten gegebenen Bereich von Wellenlängen zu detektieren, der um eine erste Wellenlänge $A_0$ herum zentriert ist, wobei die Detektionsstruktur (10) umfasst:

    - einen Träger (100), der eine Empfangsfläche (101) aufweist, die dazu ausgelegt ist, wenigstens einen Teil der elektromagnetischen Strahlung zu empfangen, und in dem ein Fabry-Perot-Hohlraum (120) vorgesehen ist, der sich wenigstens teilweise entlang einer Dicke des Trägers erstreckt, wobei der Fabry-Perot-Hohlraum (120) in eine erste Öffnung (121) der Empfangsfläche (101) mündet und durch wenigstens ein leitfähiges Medium mit negativer Permitivität (127) von dem Träger (100) begrenzt ist, wobei der Fabry-Perot-Hohlraum (120) über wenigstens einen ersten Teil der Dicke des Trägers (100) einschließlich der Empfangsfläche (101) und entlang wenigstens einer Richtung im Wesentlichen parallel zur Empfangsfläche (101) eine mittlere Länge Wc des Fabry-Perot-Hohlraums aufweist, wobei der Fabry-Perot-Hohlraum wenigstens ein erstes Einschlussmedium (125) mit einem Brechungsindex $n_d$ aufnimmt,
    - eine Absorptionsregion (131), die dazu konfiguriert ist, die elektromagnetische Strahlung zu absorbieren, wobei die Absorptionsregion (131) einen Brechungsindex $n_a$ aufweist,
    - wobei die mittlere Länge Wc des Fabry-Perot-Hohlraums im Wesentlichen gleich $A_0/(2.n_{eff})$ ist, wobei $n_{eff}$ ein effektiver Brechungsindex einer in der Absorptionsregion (131) geführten Mode mit der ersten Wellenlänge $\lambda_0$ ist,

    wobei die Detektionsstruktur (10) **dadurch gekennzeichnet ist, dass**

    - die Absorptionsregion eine Dicke $h_a$ kleiner als $\lambda_0/(5.n_a)$ aufweist,
    - die Absorptionsregion (131) in dem Fabry-Perot-Hohlraum in einem Abstand $h_1$ von der ersten Öffnung (121) des Fabry-Perot-Hohlraums untergebracht ist, der zwischen $\lambda_0/(50.n_d)$ und $\lambda_0/(4.n_d)$ enthalten ist,
    - die Dicke, des wenigstens einen ersten Teils größer oder gleich $h_1$ ist,
    - der Brechungsindex $n_d$ des wenigstens einen ersten Einschlussmediums kleiner als 80% des Brechungsindex $n_a$ der Absorptionsregion ist.

2. Detektionsstruktur nach Anspruch 1, bei der der Fabry-Perot-Hohlraum über einen zweiten Teil der Dicke des Trägers wenigstens eine Abmessung entlang wenigstens einer Richtung im Wesentlichen parallel zur Empfangsfläche (101) aufweist, die zwischen 80% und 120% der mittleren Länge Wc des Fabry-Perot-Hohlraums enthalten ist.

3. Detektionsstruktur (10) nach Anspruch 1 oder 2, bei der die Absorptionsregion (130) in einer Absorptionsschicht (131) vorgesehen ist, wobei sich die Absorptionsschicht (131) außerhalb des Fabry-Perot-Hohlraums (120) entlang einer Ebene im Wesentlichen parallel zur Empfangsfläche (101) erstreckt.

4. Detektionsstruktur (10) nach einem der Ansprüche 1 bis 3, bei der der Fabry-Perot-Hohlraum (120) entgegengesetzt zu der ersten Öffnung wenigstens teilweise durch eine reflektierende Wand (122) geschlossen ist, die dazu konfiguriert ist, die elektromagnetische Strahlung zu reflektieren, wobei die reflektierende Wand (122) in einem Abstand $h_3$ von der Absorptionsregion angeordnet ist, der zwischen $\lambda_0/(10.n_d)$ und $\lambda_0/(2.n_d)$ enthalten ist, wobei $n_d$ der Brechungsindex des ersten Einschlussmediums ist, wobei der Abstand $h_3$ zwischen der reflektierenden Wand (122) und der Absorptionsregion vorzugsweise zwischen $\lambda_0/(7.n_d)$ und $\lambda_0/(4.n_d)$ enthalten ist, und vorzugsweise im Wesentlichen gleich $\lambda_0/(5.n_d)$ ist.

5. Detektionsstruktur (10) nach einem der Ansprüche 1 bis 3, bei der der Fabry-Perot-Hohlraum (120) entgegengesetzt zu der ersten Öffnung (121) eine zweite Öffnung aufweist, wobei der Abstand $h_2$ zwischen der zweiten Öffnung und der Absorptionsregion größer als $\lambda_0/(2.n_d)$ ist.

6. Detektionsstruktur (10) nach einem der Ansprüche 1 bis 5, bei der die Detektionsstruktur (10) wenigstens eine Schicht zur Einstellung des Brechungsindex $n_r$ umfasst, die zwischen der Absorptionsregion (131) und dem Einschlussmedium (125) angeordnet ist, wobei die Schicht zur Einstellung des Brechungsindex einen Brechungsindex aufweist, dessen Wert zwischen dem Brechungsindex $n_d$ des wenigstens einen Einschlussmediums und dem Brechungsindex $n_a$ der Absorptionsschicht enthalten bleibt, wobei er von der Absorptionsregion (131) in Richtung des Einschlussmediums (125) abnimmt.

7. Detektionsstruktur (10) nach einem der Ansprüche 1 bis 6, umfassend ein zweites Einschlussmedium, wobei das zweite Einschlussmedium in dem Fabry-Perot-Hohlraum entgegengesetzt zu der ersten Öffnung untergebracht ist, wobei das erste Einschlussmedium zwischen der Absorptionsregion und dem zweiten Einschlussmedium eingefügt ist, wobei das zweite Einschlussmedium einen Brechungsindex $n_{d'}$ aufweist, der kleiner als der Brechungsindex $n_d$ des ersten Einschlussmediums ist.

8. Detektionsstruktur (10) nach einem der Ansprüche 1 bis 7, wobei das wenigstens eine erste Einschlussmedium (125) ferner außerhalb des Fabry-Perot-Hohlraums (125) angeordnet ist, wobei das erste Einschlussmedium (125) in seinem Teil außerhalb des Fabry-Perot-Hohlraums (120) eine Beschichtung des leitfähigen Mediums mit negativer Permitivität (127) mit einer Dicke $h_1$ kleiner als $h_1$ bildet.

9. Detektionsstruktur (10) nach einem der Ansprüche 1 bis 7, ferner umfassend ein Einfallsmedium (110) stromaufwärts des Trägers (100) in der Ausbreitungsrichtung der elektromagnetischen Strahlung, wobei das Einfallsmedium (110) dazu konfiguriert ist, die elektromagnetische Strahlung zu empfangen und sie zu dem Träger zu transmittieren, wobei das Einfallsmedium (110) einen Brechungsindex $n_{ext}$ aufweist, der kleiner oder gleich dem Brechungsindex $n_d$ des ersten Einschlussmediums (125) ist, wobei das erste Einschlussmedium (125) integral in dem Fabry-Perot-Hohlraum (120) enthalten ist.

10. Detektionsvorrichtung für elektromagnetische Strahlungen, umfassend eine Mehrzahl von Detektionsstrukturen (10) nach einem der Ansprüche 1 bis 9, wobei jede der Detektionsstrukturen (10) dazu ausgelegt ist, eine elektromagnetische Strahlung in dem wenigstens einem ersten gegebenen Bereich von Wellenlängen zu detektieren, der um die erste Wellenlänge $\lambda_0$ herum zentriert ist, wobei die Detektionsstrukturen (10) periodisch mit einer Periodizität kleiner als $\lambda_0/n_{ext}$ angeordnet sind, wobei $n_{ext}$ der Brechungsindex eines Einfallsmediums (110) stromaufwärts von dem Träger (100) in der Ausbreitungsrichtung der elektromagnetischen Strahlung ist, und vorzugsweise kleiner als 75% von $\lambda_0/n_{ext}$.

11. Verfahren zur Herstellung einer Detektionsstruktur (10) für elektromagnetische Strahlungen, die dazu ausgelegt ist, eine elektromagnetische Strahlung in wenigstens einem ersten gegebenen Bereich von Wellenlängen zu detektieren, der um eine erste Wellenlänge $\lambda_0$ herum zentriert ist, wobei das Herstellungsverfahren die folgenden Schritte umfasst:

    - Bereitstellen einer Absorptionsregion (131) mit einer Dicke $h_a$ kleiner als $\lambda_0/(5.n_a)$, wobei die Absorptionsregion (131) einen Brechungsindex $n_a$ aufweist und wenigstens einem Einschlussmedium (125) mit einem Brechungsindex $n_d$ kleiner als 80% des Brechungsindex $n_a$ der Absorptionsregion (131) zugeordnet ist,
    - Bilden eines Fabry-Perot-Hohlraums (120) derart, dass dort wenigstens teilweise das wenigstens eine erste Einschlussmedium (125) und die Absorptionsregion (131) untergebracht werden, wobei der Fabry-Perot-Hohlraum (120) lateral durch wenigstens ein erstes leitfähiges Medium mit negativer Permitivität (127) mit einem effektiven Brechungsindex ($n_{eff}$) einer in der Absorptionsregion (131) geführten Mode mit der Wellenlänge $\lambda_0$ begrenzt ist, wobei der Fabry-Perot-Hohlraum (120) die Absorptionsregion (131) in einem Abstand $h_1$ von der ersten Öffnung (121) des Fabry-Perot-Hohlraums (120) aufnimmt, der zwischen $\lambda_0/(50.n_d)$ und $\lambda_0/(4.n_d)$ enthalten ist,

    wobei die Bildung des Fabry-Perot-Hohlraums die Bildung eines Trägers (100) ermöglicht, der eine Empfangsfläche (101) aufweist, die die erste Öffnung (121) aufweist, in die der Fabry-Perot-Hohlraum (120) mündet, wobei sich der Fabry-Perot-Hohlraum (120) wenigstens teilweise entlang einer Dicke des Trägers (100) erstreckt und über wenigstens einen ersten Teil der Dicke des Trägers (100) einschließlich der Empfangsfläche (101) und entlang wenigstens einer Richtung im Wesentlichen parallel zur Empfangsfläche (101) eine mittlere Länge Wc des Fabry-Perot-Hohlraums aufweist, die im Wesentlichen gleich $\lambda_0/(2.n_{eff})$ ist, wobei $n_{eff}$ ein effektiver Brechungsindex einer in der Absorptionsregion (131) geführten Mode mit der Wellenlänge $\lambda_0$ ist.

12. Verfahren zur Herstellung einer Detektionsstruktur (10) nach Anspruch 11, bei dem während des Schritts des Bereitstellens der Absorptionsregion (131) der Träger (310) bereitgestellt wird, umfassend ein Substrat (320), eine Absorptionsschicht (130) und eine Passivierungsschicht, die aufeinander folgen, wobei das Substrat und/oder die Passivierungsschicht dazu ausgelegt sind, das wenigstens eine Einschlussmedium zu bilden, wobei der Schritt des Bildens eines Fabry-Perot-Hohlraums (120) die folgenden Teilschritte umfasst:

    - lokalisiertes Ätzen des Trägers (310) derart, dass wenigstens ein erster Durchbruch gebildet wird, der dem leitfähigen Medium mit negativer Permativität entspricht, wobei der wenigstens einen Durchbruch einen Hohlraum begrenzt, der wenigstens teilweise das Einschlussmedium (125) und die Absorptionsregion (131) aufnimmt,
    - Füllen des wenigstens einen Durchbruchs mit dem Material des leitfähigen Mediums mit negativer Permitivität (127) derart, dass das leitfähige Medium mit negativer Permitivität (127) und somit der Fabry-Perot-Hohlraum (120) gebildet wird.

13. Verfahren zur Herstellung nach Anspruch 11 oder 12, bei dem ferner die folgenden Schritte vorgesehen sind:

    - Bereitstellen eines zweiten Trägers (201), der eine Steuerschaltung (200) umfasst, wobei die Steuerschaltung (200) wenigstens einen Kontaktpunkt aufweist,
- Anschließen der Detektionsstruktur an die Steuerschaltung durch Indiumkugel-Hybridisierung des leitfähigen Reflektormediums (127) an den ersten Kontaktpunkt.

14. Verfahren zur Herstellung nach Anspruch 12, bei dem vor dem Schritt des lokalisierten Ätzens die folgenden Schritte vorgesehen sind:

- Bereitstellen eines zweiten Trägers (201), der eine Steuerschaltung (200) umfasst, wobei die Steuerschaltung (200) wenigstens einen Kontaktpunkt aufweist,
- Kleben des ersten Trägers (310) auf eine Fläche des ersten Trägers (200), umfassend den wenigstens einen Kontaktpunkt,

wobei während des Teilschritts des lokalisierten Ätzens der wenigstens eine Durchbruch auf den Kontaktpunkt mündet, derart, dass während des Teilschritts des Füllens des wenigstens einen Durchbruchs das leitfähige Material mit negativer Permitivität (127) auch in Kontakt mit dem wenigstens einen Kontaktpunkt aufgebracht wird.

**Claims**

1. Electromagnetic radiation detector structure (10) adapted to detect electromagnetic radiation in at least one first given range of wavelengths centred around a first wavelength $\lambda_0$, the detector structure (10) comprising:

- a support (100) having a receiving surface (101) arranged to receive at least part of the electromagnetic radiation and wherein there is arranged a Fabry-Perot cavity (120) extending at least in part along a thickness of said support, said Fabry-Perot cavity (120) leading onto a first opening (121) of said receiving surface (101) and being delimited by at least one conductive medium having negative permittivity (127) of said support (100), the Fabry-Perot cavity (120) having a mean Fabry-Perot cavity length Wc on at least one first portion of thickness of the support (100) including the receiving surface (101) and in at least one direction substantially parallel to the receiving surface (101), the Fabry-Perot cavity housing at least one first confinement medium (125) of refractive index $n_d$;
- an absorption region (131), configured to absorb electromagnetic radiation, the absorption region (131) having a refractive index $n_a$,
- the mean Fabry-Perot cavity length Wc being

substantially equal to $\lambda_0/(2.n_{eff})$, with $n_{eff}$ being an effective refractive index of a guided mode in the absorption region (131) at the first wavelength $\lambda_0$;

The detector structure (10) **being characterized in that:**

- the absorption region has a thickness $h_a$ of less than $\lambda_0/(5.n_a)$;
- the absorption region (131) is housed in the Fabry-Perot cavity at a distance $h_1$ from the first opening (121) of said Fabry-Perot cavity of between $\lambda_0/(50.n_d)$ and $\lambda_0/(4.n_d)$;
- the thickness of the at least one first portion is equal to or greater than $h_1$;
- the refractive index $n_d$ of the at least one first confinement medium being lower than 80 % of the refractive index $n_a$ of the absorption region.

2. The detector structure according to claim 1, wherein the Fabry-Perot cavity on a second portion of the thickness of the support has at least one dimension in at least one direction substantially parallel to the receiving surface (101) of between 80 % and 120 % the mean Fabry-Perot cavity length Wc.

3. The detector structure (10) according to claim 1 or 2, wherein the absorption region (130) is arranged in an absorption layer (131), said absorption layer (131) extending outside the Fabry-Perot cavity (120) in a plane substantially parallel to the receiving surface (101).

4. The detector structure (10) according to any of claims 1 to 3, wherein the Fabry-Perot cavity (120), opposite the first opening, is at least partly closed by a reflective wall (122) configured to reflect the electromagnetic radiation, said reflective wall (122) being arranged at a distance $h_3$ from the absorption region of between $\lambda_0/(10.n_d)$ and $\lambda_0/(2.n_d)$, with $n_d$ being the refractive index of the first confinement medium, said distance $h_3$ between the reflective wall (122) .

5. The detector structure (10) according to any of claims 1 to 3, wherein the Fabry-Perot cavity (120) has a second opening opposite the first opening (121), the distance $h_2$ between said second opening and the absorption region being greater than $\lambda_0/(2.n_d)$.

6. The detector structure (10) according to any of claims 1 to 5, wherein the detector structure (10) comprises a least one adaptation layer of refractive index $n_r$ arranged between the absorption region (131) and the confinement medium (125), the refractive index of said adaptation layer having a value which is included between the refractive index $n_d$ of the at least one confinement medium and the refractive index $n_a$ of the absorption layer, the refractive index value of the adaptation layer decreasing from the absorption region (131) towards the confinement medium (125).

7. The detector structure (10) according to any of claims 1 to 6 comprising a second confinement medium, said second confinement medium being housed in the Fabry-Perot cavity opposite the first opening, with the first confinement medium interposed between the absorption region and said second confinement medium, the second confinement medium having a refractive index $n_{d'}$ lower than the refractive index $n_d$ of the first confinement medium.

8. The detector structure (10) according to any of claims 1 to 7, the at least one first confinement medium (125) also being arranged outside the Fabry Perot cavity (125), said first confinement medium (125) at the part thereof outside the Fabry-Perot cavity (120) forming a coating for the conductive medium having negative permittivity (127) of thickness $h_{1'}$ less than $h_1$.

9. The detector structure (10) according to any of claims 1 to 7 further comprising an incident medium (110) upstream of the support (100), in the direction of propagation of electromagnetic radiation, the incident medium (110) being configured to receive and transmit electromagnetic radiation to the support, the incident medium (110) having a refractive index $n_{ext}$ equal to or lower than the refractive index $n_d$ of the first confinement medium (125), wherein the first confinement medium (125) is entirely contained within the Fabry-Perot cavity (120).

10. Device for the detection of electromagnetic radiation comprising a plurality of detector structures (10) according to any of claims 1 to 9, each of the detector structures (10) being adapted to detect electromagnetic radiation in the at least one first given range of wavelengths centred around the first wavelength $\lambda_0$, said detector structures (10) being arranged periodically with periodicity of less than $\lambda_0/n_{ext}$ where $n_{ext}$ is the refractive index of an incident medium (110) upstream of the support (100) in the direction of propagation of electromagnetic radiation.

11. Method for manufacturing an electromagnetic radiation detector structure (10) adapted to detect electromagnetic radiation in at least one first given range of wavelengths centre around a first wavelength $\lambda_0$, the manufacturing method comprising the following steps:

   - providing an absorption region (131) of thickness $h_a$ less than $\lambda_0/(5.n_a)$, said absorption region (131) having a refractive index $n_a$ and being associated with at least one confinement medium (125) of refractive index $n_d$ lower than 80 % of the refractive index $n_a$ of the absorption region (131),
   - forming a Fabry-Perot cavity (120) so as to house at least partly therein the at least one first confinement medium (125) and the absorption region (131), the Fabry-Perot cavity (120) being laterally delimited by at least one first conductive medium having negative permittivity (127) with $n_{eff}$ being an effective refractive index of a guided mode in the absorption region (131) at wavelength $\lambda_0$, said Fabry-Perot cavity (120) housing the absorption region (131) at a distance $h_1$ from the first opening (121) of said Fabry-Perot cavity (120) of between $\lambda_0/(50.n_d)$ and $\lambda_0/(4.n_d)$, said forming of the Fabry Perot cavity allowing the formation of a support (100) having a receiving surface (101) arranged to receive at least part of the electromagnetic radiation, the receiving surface having the first opening (121) into which the Fabry Perrot cavity (120) leads, the Fabry-Perot cavity (120) extending at least in part along a thickness of said support (100) and, on at least one first portion of thickness of the support (100) including the receiving surface (101) and in at least one direction substantially parallel to the receiving surface (101), having a mean Fabry-Perot cavity length Wc substantially equal to $\lambda_0/(2.n_{eff})$, with $n_{eff}$ being an effective refractive index of a guided mode in the absorption region (131) at wavelength $\lambda_0$.

12. Method for manufacturing a detector structure (10) according to claim 11, wherein at the step to provide the absorption region (131), there is provided the support (310) comprising a substrate (320), an absorption layer (130) and a passivation layer in succession, at least one among the substrate and passivation layer being intended to form the at least one confinement medium,
   the step to form a Fabry-Perot cavity (120) comprising the following substeps:

   - localised etching of the support (310) to make at least one first penetration corresponding to the conductive medium having negative permittivity, the at least one penetration delimiting a cavity housing at least in part the confinement medium (125) and the absorption region (131);
   - filling the at least one penetration with the material of conductive medium having negative permittivity (127) to form said conductive medium having negative permittivity (127) and hence the Fabry-Perot cavity (120).

13. The manufacturing method according to claim 11 or 12 further including:
providing a second support (201) comprising a control circuit (200), said control circuit (200) having at least one contact pad;

    - connecting the detector structure to the control circuit via indium bump hybridization of the conducting reflective medium (127) to the first contact pad.

14. The manufacturing method according to claim 12, where prior to the localised etching step the following steps are provided:

    - providing a second support (201) comprising a control circuit (200), said control circuit (200) having at least one contact pad;
    - bonding the first support (310) onto a surface of the first support (200) comprising the at least one contact pad,

wherein during the localised etching, the at least one penetration leads onto the contact pad, so that during the sub-step to fill the at least one penetration, the conductive material having negative permittivity (127) is also deposited in contact with the at least one contact pad.

FIG. 1A
Art Antérieur

FIG. 1B
Art Antérieur

FIG. 2

FIG. 3

FIG. 4A

FIG. 4B

27

FIG. 4C

FIG. 5A

28

FIG. 5B

FIG. 6

FIG. 7

FIG. 8A

FIG. 8B

FIG. 8C

10

127

130

121    101

next    110

$w_c$    $h_1$

na

131

$h_2$    nd

120    $w_c'$    125

127

123

FIG. 9A

10

130

121    101

next    110

$h_1$

na

$h_3$    131    100

nd

120    125

127    122

$w_c$

FIG. 9B

FIG. 9C

FIG. 9D

FIG. 9E

FIG. 9F

FIG. 9G

FIG. 9H

FIG. 10A

FIG. 10B

FIG. 11A

FIG. 11B

134

129

127

128

140

129A

132   133

131

## FIG. 12A

131

133   132

129A   140

130

129

125

100

128

134   $W_C$

121   100

101

## FIG. 12B

FIG. 13

FIG. 14A

FIG. 14B

140

127  128  129

125

130

320

N  P

133  132  134

131

130  127

129

P

N

133  132  128

131

FIG. 14C

FIG. 14D

FIG. 14E

FIG. 15

130    132    134    133

# FIG. 16A

130    132    134   133

# FIG. 16B

130   110   132   134   133

# FIG. 16C

131

130   110    132    133

128   125    134   127   129

# FIG. 16D

320

130

330

FIG. 17A

210
201
200
122

133   133   132

130

210
201
200

120

122   126

FIG. 17B

131
133   132

133

130

210
201
200

125

122   126

FIG. 17C

FIG. 17D

FIG. 18A

FIG. 18B

FIG. 18C

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- FR 2992471 A1

- US 8125043 B2